# EUROPEAN PATENT SPECIFICATION

(11) **EP 3 301 725 B1**
(45) Date of publication and mention of the grant of the patent: **18.11.2020**
(21) Application number: 17193970.5
(22) Date of filing: 29.09.2017
(51) Int. Cl.: H01L 29/872, H01L 29/04, H01L 29/24

(54) **SEMICONDUCTOR DEVICE AND SEMICONDUCTOR SYSTEM INCLUDING SEMICONDUCTOR DEVICE**
HALBLEITERBAUELEMENT UND HALBLEITERANORDNUNG MIT HALBLEITERBAUELEMENT
DISPOSITIF SEMI-CONDUCTEUR ET SYSTÈME À SEMI-CONDUCTEUR COMPORTANT UN DISPOSITIF SEMI-CONDUCTEUR

(30) Priority: 03.10.2016 JP 2016196066; 03.10.2016 JP 2016196067; 10.02.2017 JP 2017022692
(43) Date of publication of application: 04.04.2018
(73) Proprietor: Flosfia Inc., Kyoto 615-8245 (JP)
(72) Inventor: Oda, Masaya, Kyoto, 6158245 (JP); Tokuda, Rie, Kyoto, 6158245 (JP); Kambara, Hitoshi, Kyoto, 6158245 (JP); Kawara, Katsuaki, Kyoto, 6158245 (JP); Hitora, Toshimi, Kyoto, 6158245 (JP)
(74) Representative: Gulde & Partner

(56) References cited:
- EP-A1- 2 942 803
- EP-A1- 3 182 464
- WO-A1-2016/013554

## Description

### BACKGROUND OF THE INVENTION

### Field of the Invention

The present disclosure relates to a semiconductor device, particularly to a Schottky barrier diode. Also, the present disclosure relates to a semiconductor system including a semiconductor device, particularly a Schottky barrier diode.

### Description of the Related Art

It is open to the public that a gallium oxide (Ga₂O₃) semiconductor device includes an n-side electrode that includes at least a Ti layer that is formed on a lower surface of an n-type β-Ga₂O₃ substrate by utilizing a pulsed laser deposition (PLD) method. The gallium oxide semiconductor device with the n-side electrode has ohmic characteristics at 25°C, and the n-side electrode may have two layers or more including a Ti layer and an Au layer. Also, it is open to the public that a Ga₂O₃ semiconductor device includes an n-type layer including a β-Ga₂O₃ compound semiconductor with an n-type conductivity and an electrode formed on the n-type layer to obtain Schottky characteristics, which may include switching characteristics. The electrode may include Au, Pt, or layered body of Ni and Au. Accordingly, it has been known that a metal such as Au, Pt, and Ni that belong to the tenth and eleventh groups in the periodic table is used for a Schottky electrode of a semiconductor containing a β-Ga₂O₃ (For reference, see Japanese Unexamined Patent Application Publications No. 2005-260101, No. 2009-81468, and No. 2013-12760).

Also, it is open to the public that a crystalline semiconductor film includes an oxide semiconductor as a major component. The crystalline semiconductor film has a thickness that is 1 µm or more (For reference, see International patent publication No. WO2006/013554, which, in one example, discloses a Schottky barrier diode comprising an n⁺ α-Ga₂O₃ layer, an n⁻ α-Ga₂O₃ layer, a Schottky electrode disposed on the n⁻ layer and an ohmic electrode disposed on the n⁺ layer).

Furthermore, it is open to the public that a Sn-doped Ga₂O₃ thin film was deposited on a n⁺ Si-substrate by metal-organic chemical vapor deposition. The Ga₂O₃ film was found to be amorphous-like and exhibited n-type conduction with Sn doping (See Non-patent document, "UV and Visible Electroluminescence From a Sn:Ga2O3/n+-Si Heterojunction by Metal-Organic Chemical Vapor Deposition", IEEE TRANSACTIONS ON ELECTRON DEVICES. VOL.58, NO.5 MAY 2011".

Also, it is open to the public that a donor doping technique for a β-Ga₂O₃ by using Si-ion (Si⁺) implantation (See Kohei Sasaki et al., "Si-Ion Implantation Doping in a β-Ga2O3 and Its Application to Fabrication of Low-Resistance Ohmic Contacts", Applied Physics Express 6 (2013) 086502.

Further information on semiconductor devices comprising GaO and their respective properties are disclosed in EP 3 182 464 A1 that has been published after the relevant date of the present application. Also EP 2 952 803 A1 refers to a crystalline multilayer structure including a corundum-structure oxide semiconductor as well as to a semiconductor device with such structure.

### SUMMARY OF THE INVENTION

In a first aspect of a present disclosure, a Schottky barrier diode is provided in accordance with the appended claims. In a second aspect of a present disclosure, a semiconductor system is provided in accordance with the appended claims.

### BRIEF DESCRIPTION OF THE DRAWINGS

FIG. 1 shows a schematic view of a first embodiment of a semiconductor device according to the present invention.
FIG. 2 shows a schematic view of a second embodiment of a semiconductor device according to the present invention.
FIG. 3 shows a schematic view of a first metal layer, which may be included in an example of a semiconductor device according to a present disclosure.
FIG. 4 shows a schematic view of a second metal layer, which may be included in an example of a semiconductor device according to a present disclosure.
FIB. 5 shows a schematic diagram of a mist chemical vapor deposition (CVD) apparatus that may be used according to an example of method of a present disclosure.
FIG. 6 shows a schematic diagram of a mist chemical vapor deposition (CVD) apparatus that may be used according an example of method of a present disclosure.
FIG. 7 shows a measurement result of current voltage (IV) characteristics of a semiconductor device according to an example of a present disclosure.
FIG. 8 shows a measurement result of current voltage (IV) characteristics of a semiconductor device according to a present disclosure.
FIG. 9 shows a measurement result of current voltage (IV) characteristics of a semiconductor device according to an example of a present disclosure.
FIG. 10 shows a measurement result of current voltage (IV) characteristics of a comparison example of a semiconductor device including a Schottky electrode that is made of Pt.
FIG. 11 shows a measurement result of switching characteristics of a semiconductor device according to an example of a present disclosure, showing current at the vertical axis and time (second) at the horizontal axis.
FIG. 12 shows schematic view of a semiconductor system according to an example of a present disclosure.
FIG. 13 shows a schematic view of a semiconductor system according to an example of a present disclosure.
FIG. 14 shows a schematic view of a circuit diagram of power supply of a semiconductor system according to an example of a present disclosure.
FIG. 15 shows a result of Capacitance-Voltage (CV) measurement of a semiconductor device according to an embodiment of the present invention.
FIG. 16 shows a result of forward current density-voltage (JV) measurement of a semiconductor device according to an embodiment of the present invention.
FIG. 17 shows a result of backward current density-voltage (JV) measurement according to an embodiment of the present invention.
FIG. 18 shows a distribution of excess concentration of n-type dopant in a depth direction.
FIG. 19 shows a result of backward current density-voltage (JV) measurement according to an embodiment of the present invention.

### DETAILED DESCRIPTION OF EXAMPLES

As used herein, the term "and/or" includes any and all combinations of one or more of the associated listed items.

As illustrated in the figures submitted herewith, some sizes of structures or portions may be exaggerated relative to other structures or portions for illustrative purposes. Relative terms such as "below" or "above" or "upper" or "lower" may be used herein to describe a relationship of one element, layer or region to another element, layer or region as illustrated in the figures. It will be understood that these terms are intended to encompass different orientations of a film, a device, and/or a system in addition to the orientation depicted in the figures.

According to a first aspect of a present disclosure, a semiconductor device includes a semiconductor layer including a crystalline oxide semiconductor that contains gallium, and a Schottky electrode that is positioned on the semiconductor layer. The crystalline oxide semiconductor of the semiconductor layer may contain gallium as a major component. The term "major component" herein means, for example, in a case that a crystalline oxide semiconductor of a crystalline oxide semiconductor layer is α-Ga₂O₃, an atomic ratio of gallium in a metal element in the crystalline oxide semiconductor layer may be 0.5 or more.

According to an example of a present disclosure, the atomic ratio of gallium in a metal element in a crystalline oxide semiconductor layer may be preferably 0.7 or more. For a present disclosure, the atomic ratio of gallium in a metal element in a crystalline oxide semiconductor layer may be further preferably 0.8 or more.

A crystalline oxide semiconductor device may include a crystalline oxide semiconductor layer containing a crystalline oxide semiconductor with a crystalline structure, which may be a corundum structure or a β-gallia structure. However, according to a present disclosure, a crystalline semiconductor device including a crystalline semiconductor layer containing a corundum structure would be preferable to a crystalline semiconductor device including a crystalline semiconductor layer containing a β-gallia structure.

Also, a crystalline oxide semiconductor layer according to an example of a present disclosure, the crystalline oxide semiconductor layer preferably contains an InAlGaO-based semiconductor.

Furthermore, the thickness of the crystalline oxide semiconductor layer may not be particularly limited herein. The thickness of the crystalline oxide semiconductor layer may be 1 µm or less. Also, the thickness of the crystalline oxide semiconductor layer may be 1 µm or more.

The semiconductor layer includes a surface area that is 3 mm² or less. Even if the surface area is as small as 3 mm² or less, it is possible to obtain a semiconductor device to which an electric current that is 1A or more is applicable. The electric current that is applicable to the semiconductor device may be 10A or more.

The crystalline oxide semiconductor of the semiconductor layer includes a corundum structure. The Schottky electrode includes at least one metal selected from the fourth group, the fifth group, the sixth group, the seventh group, the eighth group and the ninth group in the periodic table, that is the periodic table of chemical elements. Also, the crystalline oxide semiconductor of the semiconductor layer may contain α-Ga₂O₃ or a mixed crystal of α-Ga₂O₃. If the crystalline oxide semiconductor device includes the semiconductor layer that contains α-Ga₂O₃ or a mixed crystal of α-Ga₂O₃ and the Schottky electrode that includes at least one metal selected from the fourth group, the fifth group, the sixth group, the seventh group, the eighth group and the ninth group, it is possible to obtain a semiconductor device that may be superior in semiconductor characteristics, which may include electric characteristics as a semiconductor.
According to an example of a present disclosure, the semiconductor layer may be with a dielectric breakdown field that is 6 MV/cm or more.

Also, according to an example of a present disclosure, a crystalline oxide semiconductor layer may contain a dopant. As a dopant, for example, tin, germanium, silicon, titanium, zirconium, vanadium, or niobium is suggested. However, a dopant is not limited thereto, and the dopant may be a known one. Examples of the dopant may include n-type dopants and p-type dopants.

According to an example of a present disclosure, the dopant may be at least one selected among tin, germanium and silicon. Also, according to an example of the present disclosure, the dopant may be preferably tin. Also, it is noted that impurities may be contained in a crystalline oxide semiconductor layer during a film-formation process, for example, and may function as a dopant. Content of dopant in composition of the crystalline oxide semiconductor film may be preferably 0.0000000001 atom% or more.

Also, content of dopant in composition of the crystalline oxide semiconductor film may be preferably to be in a range of 0.0000000001 atom% to 20 atom%. Furthermore, content of dopant in composition of the crystalline oxide semiconductor film may be further preferably to be in a range of 0.0000000001 atom% to 10 atom%. If the content of dopant in composition of the crystalline oxide semiconductor film becomes in a range that is preferable or further preferable, the crystalline oxide semiconductor film or a crystalline oxide semiconductor layer that is arranged in a semiconductor device would be more enhanced in electrical characteristics.

According to an aspect of a present disclosure, a semiconductor device includes a semiconductor layer including a first semiconductor layer and a second semiconductor layer, and a Schottky electrode that is positioned on the first semiconductor layer. The first semiconductor layer may include a crystalline oxide semiconductor containing gallium. The second semiconductor layer may include a crystalline oxide semiconductor containing gallium.

The Schottky electrode may include at least one metal selected from the fourth group, the fifth group, the sixth group, the seventh group, the eighth group and the ninth group in the periodic table. At least one of the first semiconductor layer and the second semiconductor layer may include a surface area that is 3 mm² or less.

The first carrier concentration may be smaller than the second carrier concentration. The Schottky electrode may contain at least one metal selected from the fourth group, the fifth group, and the sixth group in the periodic table. Also, the Schottky electrode may contain a transition metal selected from the fourth group in the periodic table. The crystalline oxide semiconductor of the first semiconductor layer includes a corundum structure, and the crystalline oxide semiconductor of the second semiconductor layer includes a corundum structure.

Also, the crystalline oxide semiconductor of the first semiconductor layer may contain α-Ga₂O₃ or a mixed crystal of α-Ga₂O₃. The crystalline oxide semiconductor of the second semiconductor layer may contain α-Ga₂O₃ or a mixed crystal of α-Ga₂O₃.

Accordingly, the semiconductor device according to this example may be superior in semiconductor characteristics.

Also, at least one of the first semiconductor layer and the second semiconductor layer may include a surface that is 3mm² or less. The first semiconductor layer may include a first carrier concentration. The second semiconductor layer include a second carrier concentration. The first carrier concentration may be smaller than the second carrier concentration. In the second example, if the semiconductor layer that includes the first semiconductor layer and the second semiconductor layer, each of which may contain gallium as a major component.

Furthermore, the thickness of the crystalline oxide semiconductor layer may not be particularly limited herein. According to an example of a present disclosure, the thickness of the crystalline oxide semiconductor layer may be 1 µm or less. Also, according to an example of a present disclosure, the thickness of the crystalline oxide semiconductor layer may be 1 µm or more.

The semiconductor layer may include a surface area that is 3 mm² or less. Even if the surface area is as small as 3 mm² or less, it is possible to obtain a semiconductor device to which an electric current that is 1A or more is applicable. Furthermore, the electric current that is applicable to the semiconductor device may be 10A or more.

The first semiconductor layer with a first thickness and the second semiconductor layer with a second thickness are 40 µm or less as a total thickness of the first thickness of the first semiconductor layer and the second thickness of the second semiconductor layer.

The semiconductor layer may be with a dielectric breakdown field that is 6 MV/cm or more.

A semiconductor device according to an aspect of a present disclosure includes a semiconductor layer that includes a crystalline oxide semiconductor that contains gallium. The semiconductor further includes a Schottky electrode that is positioned on the semiconductor layer, and the semiconductor layer includes a surface area that is 1 mm² or less. According to a calculated result of evaluation value of thermal resistance mentioned in Example IV, a semiconductor device according to an example of a present disclosure is able to obtain semiconductor characteristics even if the semiconductor device is downsized.

For example, even if a crystalline semiconductor layer has a thickness that is 12 µm or less and a surface area that is 1 mm² or less, a semiconductor to which an electric current that is 1A or more is applicable is obtainable. A crystalline semiconductor layer may include a single crystal or a polycrystal.

### (Atomization and/or forming droplets process)

At the atomization and/or forming droplets process, the raw material solution may be atomized and/or droplets of the raw material solution may be formed. A method to atomize the raw material solution and/or to form droplets of the raw material solution is not limited herein. The method to atomize the raw material solution and/or to form droplets of the raw material solution may be a known method if the raw material solution is able to be atomized and/or formed into droplets.

According to an example of the present disclosure, atomizing the raw material solution by ultrasonic waves to obtain mist and/or forming droplets from the raw material solution by ultrasonic waves is preferable. The mist or droplets obtained using ultrasonic waves have an initial rate of zero to be suspended in the air. The mist obtained using ultrasonic waves is capable of being suspended in a space to be delivered as a gas, is not blown like a spray, for example, and thus, is not damaged by collision energy. Accordingly, the mist obtained using ultrasonic waves is preferable. The size of droplet may not be particularly limited and a droplet may be of approximately several mm, however, according to an example of a present disclosure, the size of droplet may be 50 µm or smaller. Also, according to an example of a present disclosure, the size of droplet may be in a range of 0.1 µm to 10 µm.

### <Raw material solution>

If the raw material solution contains a material that is able to be atomized and/or to be formed into droplets, and if the raw material solution contains a deuterium, the material is not particularly limited, and thus may contain an inorganic material and/or an organic material. However, according to an example of a present disclosure, the material in the raw material solution may be a metal and/or a metal compound. The material in the raw material solution may include one or more metals selected from gallium, iron, indium, aluminum, vanadium, titanium, chromium, rhodium, nickel, cobalt, zinc, magnesium, calcium, silicon, yttrium, strontium, and barium.

According to an example of the present disclosure, a raw-material solution containing at least one metal, in the form of complex or salt, dissolved or dispersed in an organic solvent or water may be used. Examples of the form of the complex may include acetylacetonate complexes, carbonyl complexes, ammine complexes, hydride complexes. Also, examples of the form of the salt may include organic metal salts (e.g., metal acetate, metal oxalate, metal citrate, etc.), metal sulfide salt, metal nitrate salt, metal phosphate salt, metal halide salt (e.g., metal chloride salt, metal bromide salt, metal iodide salt, etc.).

The raw-material solution, may contain hydrohalic acid and/or an oxidant as an additive. Examples of the hydrohalic acid may include hydrobromic acid, hydrochloric acid, hydriodic acid. Among all, hydrobromic acid or hydroiodic acid may be preferable for a reason to obtain a film of better quality. Also, examples of the oxidant include peroxides that include hydrogen peroxide (H₂O₂), sodium peroxide (Na₂O₂), barium peroxide (BaO₂), and benzoyl peroxide (C₆H₅CO)₂O₂, hypochlorous acid (HClO), perchloric acid, nitric acid, ozone water, and organic peroxides that include peracetic acid and nitrobenzene.

The raw-material solution may contain a dopant, which is used to produce a desired electrical characteristic in a semiconductor. Examples of the dopant may include n-type dopants. The n-type dopants may include tin, germanium, silicon, titanium, zirconium, vanadium, and niobium. Also, examples of the dopant may include p-type dopants, and the dopant may not be particularly limited as long as an object of a present disclosure is not interfered with. The dopant concentration in general may be in a range of 1×10¹⁶/cm³ to 1×10²²/cm³. The dopant concentration may be at a lower concentration of, for example, approximately 1×10¹⁷/cm³ or less. According to an example of the present disclosure, the dopant may be contained at a high concentration of, for example, 1×10²⁰/cm³ or more.

A solvent of the raw-material solution is not particularly limited, and thus, the solvent may be an inorganic solvent that include water. The solvent may be an organic solvent that includes alcohol. The solvent may be a mixed solvent of the inorganic solvent and the organic solvent. According to an example of a present disclosure, the solvent contains water. Also, according to an example of a present disclosure, the solvent may be a mixed solvent of water and alcohol.

### (Carrying mist and/or droplets process)

At the process for carrying mist and/or droplets, the mist and/or droplets are delivered into a film-formation chamber by carrier gas. The carrier gas is not limited as long as an object of a present disclosure is not interfered with, and thus, the carrier gas may be an inert gas such as oxygen, ozone, nitrogen, and argon. Also, the carrier gas may be a reducing gas that may be a hydrogen gas and/or a forming gas. The carrier gas may contain one or two or more gasses. Also, a diluted carrier gas at a reduced flow rate (e.g., 10-fold diluted carrier gas) and the like may be used further as a second carrier gas. The carrier gas may be supplied from one or more locations. While the flow rate of the carrier gas is not particularly limited, the flow rate of the carrier gas may be in a range of 0.01 to 20 L/min. According to an example of the disclosure, the flow rate of the carrier gas may be preferably in a range of 1 to 10 L/min. When a diluted carrier gas is used, the flow rate of the diluted carrier gas may be in a range of 0.001 to 2L/min. Furthermore, according to an example of an disclosure, when a diluted carrier gas is used, the flow rate of the diluted carrier gas maybe in a range of 0.1 to 1L/min.

### (Film Formation Process)

At the film-formation process, a crystallinity oxide semiconductor layer is formed on a crystalline substrate by thermal reaction of the mist and/or droplets of the raw material solution. The term "thermal reaction" herein includes just a reaction of the mist and/or droplets by heat. Conditions of reaction are not particularly limited only if an object of a present disclosure is not interfered with. In the film-formation process, the thermal reaction is conducted at an evaporation temperature or higher temperature of the evaporation temperature of the solvent of the raw material solution. During the thermal reaction, the temperature should not be too high. For example, the temperature during the thermal reaction may be 1000 °C or less. The temperature during the thermal reaction is preferably 650 °C or less. According to an example of the present disclosure, the temperature during the thermal reaction is further preferably in a range of 300 °C to 650 °C. Also, the thermal reaction may be conducted in any atmosphere of a vacuum, a non-oxygen atmosphere, a reducing-gas atmosphere, and an oxygen atmosphere. Also, the thermal reaction may be conducted in any condition of under an atmospheric pressure, under an increased pressure, and under a reduced pressure. According to an example of a present disclosure, the thermal reaction is preferably conducted under an atmospheric pressure. Also, a film thickness of crystalline oxide semiconductor film is able to be set by adjusting a film-formation time.

### (A substrate)

A substrate is not particularly limited as long as it is capable of supporting a crystalline oxide semiconductor film. The material for the substrate is also not particularly limited as long as an object of the present invention are not interfered with, and the substrate may be a substrate of a known material. Also, the substrate may contain an organic compound and/or an inorganic compound.

Also, the substrate may be in any shape and may be valid for all shapes. Examples of the shape of the substrate include a plate shape, a flat plate shape and a disk shape, a fibrous shape, a rod shape, a cylindrical shape, a prismatic shape, a tubular shape, a spiral shape, a spherical shape, and a ring shape. According to an example of a present disclosure, a substrate may be selected and the thickness of the substrate may not be particularly limited.

Furthermore, a material for the substrate is not particularly limited as long as an object of the present disclosure is not interfered with, and also, the material may be a known one. A substrate with a corundum structure would be a substrate material for an example of a present disclosure. Examples of a substrate with a corundum structure include α-Al₂O₃ (sapphire substrate) and α-Ga₂O₃. Also, according to an example of a present disclosure, the substrate may be an a-plane sapphire substrate, an m-plane sapphire substrate, an r-plane sapphire substrate, a c-plane sapphire substrate, an α gallium oxide substrate (a-plane, m-plane, or r-plane), and the like. Furthermore, examples of the substrate contain a substrate material with a β-gallia structure as a major component include a β-Ga₂O₃ substrate, a mixed crystal substrate containing Ga₂O₃ and Al₂O₃, where Al₂O₃ is more than 0 wt% and 60 wt% or less, and the like. Examples of the substrate containing the substrate material with a hexagonal structure as a major component include an SiC substrate, a ZnO substrate, a GaN substrate, and the like. A metal used for the substrate material is not particularly limited while metal used for a first metal layer or a second metal layer may be selected.

According to an example of a present disclosure, a substrate may contain a metal or a corundum structure in all or part of a surface of the substrate. When the substrate contains a corundum structure, the substrate may be preferably a base substrate containing a substrate material with a corundum structure as a major component. The substrate may be preferably a sapphire substrate. The substrate may be preferably an α gallium oxide substrate. The substrate may contain aluminum, and in this case, the substrate preferably contains a substrate material containing an aluminum with a corundum structure as a major component. The substrate is preferably a sapphire substrate (preferably, a c-plane sapphire substrate, an a-plane sapphire substrate, an m-plane sapphire substrate, or an r-plane sapphire substrate). Also, the substrate may contain oxide. Examples of oxide substrate include a YSZ substrate, an MgAl₂O₄ substrate, a ZnO substrate, an MgO substrate, an SrTiO₃ substrate, an Al₂O₃ substrate, a quartz substrate, a glass substrate, a β gallium oxide substrate, a barium titanate substrate, a strontium titanate substrate, a cobalt oxide substrate, a copper oxide substrate, a chromium oxide substrate, an iron oxide substrate, a Gd₃Ga₅O₁₂ substrate, a potassium tantalate substrate, a lanthanum aluminate substrate, a lanthanum strontium aluminate substrate, a lanthanum strontium gallate substrate, a lithium niobate substrate, a tantalate lithium substrate, lanthanum strontium aluminum tantalate, a manganese oxide substrate, a neodymium gallate substrate, a nickel oxide substrate, a scandium magnesium aluminate substrate, strontium oxide, a strontium titanate substrate, a tin oxide substrate, a tellurium oxide substrate, a titanium oxide substrate, a YAG substrate, a yttrium aluminate substrate, a lithium aluminate substrate, a lithium gallate substrate, a LAST substrate, a neodymium gallate substrate, a yttrium orthovanadate substrate, and the like.

According to an example of a present disclosure, after the film formation process, annealing may be performed. The annealing temperature may not be particularly limited as long as an object of a present disclosure is not interfered with. The annealing temperature may be generally from 300°C to 650°C. According to an example of a present disclosure, the annealing temperature may be preferably from 350°C to 550°C. Also, the annealing time is generally from 1 minute to 48 hours. According to an example of a present disclosure, the annealing time may be preferably from 10 minutes to 24 hours, and further preferably from 30 minutes to 12 hours. The annealing may be performed in any atmosphere as long as an object of a present disclosure is not interfered with. The annealing may be performed in a non-oxygen atmosphere. Also, the annealing may be performed in a nitrogen atmosphere.

According to an example of a present disclosure, a crystalline oxide semiconductor film or a crystalline oxide semiconductor layer may be provided directly on a substrate or may be provided on another layer, such as a buffer layer and a stress relief layer, positioned above or below the substrate.

Layers including a crystalline oxide semiconductor layer may not be particularly limited, and thus, may be formed by a known method. However, a crystalline oxide semiconductor film may be preferably formed by a mist CVD (Chemical Vapor Deposition) apparatus.

According to an example of a present disclosure, a crystalline oxide semiconductor film may include a substrate as a crystalline oxide semiconductor layer, which may be used in a semiconductor device.

Also, according to an example of a present disclosure, a crystalline oxide semiconductor film does not include a substrate. A crystalline oxide semiconductor film that is separated from a substrate by use of a known method may be used as a semiconductor layer in a semiconductor device.

The semiconductor device includes at least a semiconductor layer that includes a crystalline oxide semiconductor and a Schottky electrode that is positioned on the semiconductor layer.

The Schottky electrode is not particularly limited as long as the Schottky electrode contains at least one metal selected from the fourth to ninth groups of the periodic table. Examples of the metal of the fourth group of the periodic table include titanium (Ti), zirconium (Zr), and hafnium (Hf). According to an example of a present disclosure, Ti may be selected as a metal used for the Schottky electrode. Examples of the metal of the fifth group of the periodic table include vanadium (V), zirconium (Zr), and hafnium (Hf). Examples of the metal of the sixth group of the periodic table include one or more metals selected from chromium (Cr), molybdenum (Mo), and tungsten (W). According to an example of a present disclosure, Cr that is expected to enhance switching characteristics of semiconductor device may be selected as a metal used for the Schottky electrode. Examples of the metal of the seventh group of the periodic table include manganese (Mn), technetium (Tc), and rhenium (Re). Examples of the metal of the eighth group of the periodic table include iron (Fe), ruthenium (Ru), and osmium (Os). Examples of the metal of the ninth group of the periodic table include cobalt (Co), rhodium (Rh), iridium (Ir). According to an example of a present disclosure, and as long as an object of a present disclosure is not interfered with, the Schottky electrode may contain a metal selected from the tenth group and the eleventh group of the periodic table. Examples of the metal of the tenth group of the periodic table include nickel (Ni), palladium (Pd), and platinum (Pt). Among all in the tenth group of the periodic table, platinum (Pt) may be selected. Examples of the metal of the eleventh group of the periodic table include copper (Cu), silver (Ag), and gold (Au). Among all in the eleventh group of the periodic table, gold (Au) may be selected.

According to an example of a present disclosure, to obtain better semiconductor properties such as switching characteristics, at least one metal is selected from the fourth group, the fifth group and the sixth group in the periodic table. Also, according to an example of a present disclosure, the Schottky electrode may contain at least one metal selected from the fourth group, the fifth group, and the sixth group in the periodic table. Furthermore, the Schottky electrode may contain a transition metal selected from the fourth group in the periodic table.

The Schottky electrode may be a metal layer of a single layer. The Schottky electrode may contain two or more metal layers and/or metal films. The two or more metal layers and/or metal films may be arranged by a method such as vacuum deposition and sputtering. Also, the two or more metal layers and/or metal films may be arranged by a known method, and not particularly limited to a particular method. Also, the Schottky electrode may include an alloy.

According to an example of a present disclosure, the Schottky electrode may contain Ti. Also, according to an example of a present disclosure, the Schottky electrode may preferably contain Au and/or Pt. A Schottky electrode containing a metal that is preferable would enhance semiconductor properties of a semiconductor device, and the semiconductor properties may include durability, dielectric breakdown voltage, withstand voltage, on-resistance, and stability.

According to an example of a present disclosure, the Schottky electrode may have a surface area that is 1 mm² or less. The Schottky electrode may preferably have a surface area that is 0.8 mm² or less.

According to an example of a present disclosure, a semiconductor device includes an ohmic electrode. The ohmic electrode may contain a metal selected from the fourth group and the eleventh group of the periodic table. The ohmic electrode may contain a same metal as a metal that is contained in a Schottky electrode. Also, the ohmic electrode may be a metal layer of a single layer or may contain two or more metal layers, which may be formed by a known method such as vacuum deposition and/or sputtering, and thus a method forming an electrode is not particularly limited. The ohmic electrode may include an alloy. According to an example of a present disclosure, the ohmic electrode may contain Ti and/or Au. The ohmic electrode may preferably contain Ti and Au.

According to an example of a present disclosure, the semiconductor device may be particularly useful for a power device. Examples of the semiconductor device according to a present disclosure include a semiconductor laser, a diode, a transistor (e.g., MESFET, etc.), and Schottky barrier diode (SBD) just for example.

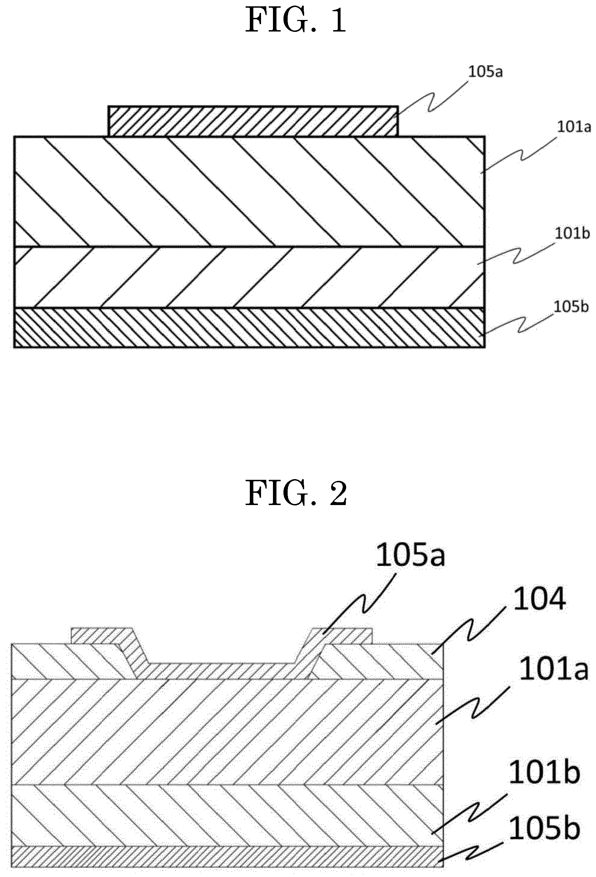

FIG. 1 shows a schematic view of a first example of a semiconductor device according to a present disclosure. In this example, the semiconductor device may be a Schottky barrier diode (SBD). The SBD shown in FIG. 1 includes an n⁻-type semiconductor layer 101a, an n⁺-type semiconductor layer 101b, a Schottky electrode 105a, and an ohmic electrode 105b.

Electrodes such as Schottky electrode and ohmic electrode may be formed by a known method, such as vacuum deposition and sputtering, for example. More specifically, for example, the Schottky electrode may be formed by laminating a first metal layer and patterning in the first metal layer using photolithography.

According to an example of a present disclosure, a semiconductor device includes a Schottky electrode 105a as a first metal layer and an ohmic electrode 105b as a second metal layer.

FIG. 2 shows a schematic view of a second example of a semiconductor device according to a present disclosure.

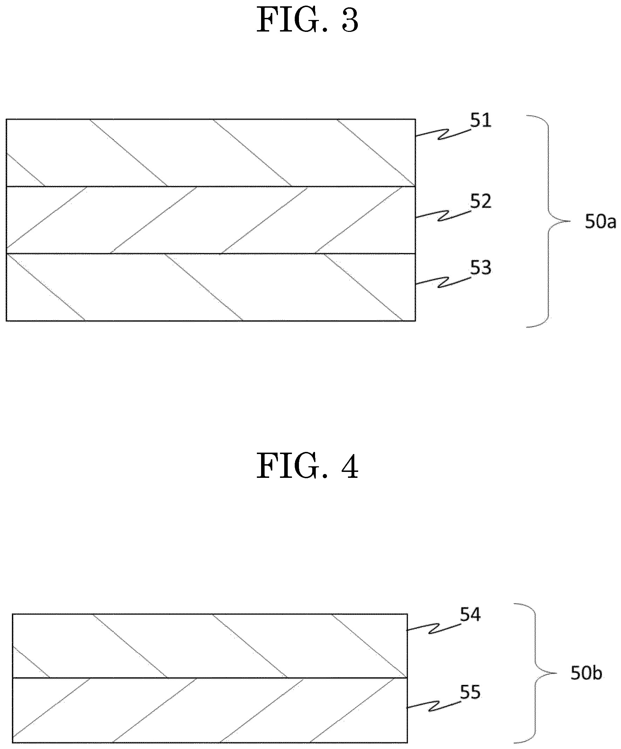

FIG. 3 shows a schematic view of a first metal layer, which may be included in an example of a semiconductor device according to a present disclosure. The first metal layer 50a may include an Au layer 51, a Ti layer 52, and a Pt layer 53. The Au layer 51 may have a thickness that is in a range of 0.1 nm to 10 µm. Also, according to an example of a semiconductor device of a present disclosure, the Au layer 51 may have a thickness that is in a range of 5 nm to 200 nm. Furthermore, according to an example of a semiconductor device of a present disclosure, the Au layer 51 may have a thickness that is preferably in a range of 10 nm to 100 nm. A metal layer included in the first metal layer and containing a metal that belongs to the fourth group of the periodic table may have a thickness that is preferably in a range of 1 nm to 500 µm. The metal may be Ti, for example. The metal layer may have a thickness that is in a range of 1 nm to 100 µm. Also, the metal layer may have a thickness that is 5 nm to 20 nm according to an example. Furthermore, the metal layer may have a thickness that is 1 µm to 100 µm.

If a metal layer included in the first metal layer and containing a metal that belongs to the tenth group of the periodic table may have a thickness that is in a range of 1nm to 10 µm. The metal may be Pt, for example.

Also, if a metal layer included in the first metal layer and containing a metal that belongs to the eleventh group of the periodic table may have a thickness that is in a range of 5 µm to 100 µm. The metal may be Ag, for example. The metal layer that is an Ag film may have a thickness that is in a range of 5 µm to 100 µm. Also, according to an example, the metal layer that is an Ag film may have a thickness that is in a range of 10 µm to 80 µm. Furthermore, the Ag film may have a thickness that is in a range of 20 µm to 60 µm, according to an example.

Furthermore, if a metal layer included in the first metal layer and containing Cu that belongs to the eleventh group of the periodic table, the Cu film may have a thickness that is in a range of 1 nm to 500 µm. Also, according to an example, the Cu film may have a thickness that is preferably in a range of 1 nm to 100 µm. The Cu film may have further preferably a thickness that is in a range of 0.5 µm to 5 µm, according to an example.

FIG. 4 shows a schematic view of a second metal layer, which may be included in an example of a semiconductor device according to a present disclosure. The second metal layer 50b may include a Ti layer 54 and an Au layer 55. The Ti layer 54 may have a thickness that is in a range of 1 nm to 500 µm. Also, according to an example of a semiconductor device of a present disclosure, the Ti layer 54 may have a thickness that is in a range of 1 nm to 100 nm. Furthermore, according to an example of a semiconductor device of a present disclosure, the Ti layer 54 may have a thickness that is preferably in a range of 5 nm to 20 nm. Also, the Ti layer 54 may have a thickness that is preferably in a range of 1 µm to 100 µm, according to an example of a semiconductor device of a present disclosure. The Au layer 55 may have a thickness that is in a range of 0.1 nm to 10 µm. According to an example of a semiconductor device of a present disclosure, the Au layer 55 may have a thickness that is preferably in a range of 5 nm to 200 nm. Furthermore, the Au layer 55 may have a thickness that is further preferably in a range of 10 nm to 100 nm.

When a reverse bias is applied to an SBD shown in Fig. 1, for example, a depletion layer (not shown) will expand in the n-type semiconductor layer 101a and make the SBD have a higher breakdown voltage. When a forward bias is applied to the SBD, electrons flow from the ohmic electrode 105b to the Schottky electrode 105a. The SBD with a higher breakdown voltage is configured to apply a large current to and expected to obtain an enhanced switching speed. It would be helpful to obtain an SBD that is reliable in characteristics as a semiconductor device.

FIG. 2 shows a schematic view of a second example of a semiconductor device according to a present disclosure. This is another example of an SBD. The SBD shown in FIG. 2 includes an n⁻-type semiconductor layer 101a, an n⁺-type semiconductor layer 101b, a Schottky electrode 105a, and an ohmic electrode 105b, and the insulating layer 104.

Examples of the material for the insulating layer 104 include GaO, AlGaO, InAlGaO, AlInZnGaO₄, AlN, Hf₂O₃, SiN, SiON, Al₂O₃, MgO, GdO, SiO₂, and/or Si₃N₄. Regarding a present disclosure, the material for the insulating layer 104 may preferably contain an insulating material with a corundum structure. The insulating layer 104 containing the corundum structure reveals semiconductor characteristics effectively at an interface. The insulating layer 104 is provided between the n⁻-type semiconductor layer and the Schottky electrode 105a. The insulating layer 104 may be formed by a known method, such as sputtering, vacuum deposition, and CVD, for example.

The SBD shown in FIG. 2 would be better in an electrically-insulating property and current controllability, compared with the SBD shown in FIG. 1. Other configuration(s) may be the same as those of the SBD in FIG. 1.

The SBD as a semiconductor device may have a capacitance with a zero-bias voltage when measured at 1 MHz, and the capacitance may be 1000pF or less. According to an example of a semiconductor device of a present disclosure, the capacitance of the semiconductor device with a zero-bias voltage may be 500pF or less when measured at 1 MHz. Furthermore, a semiconductor device according to an example of a present disclosure, the capacitance of the semiconductor device with a zero-bias voltage may be 150pF or less.

In addition, according to an example of a semiconductor device of a present disclosure, the semiconductor device may be used as a power module, an inverter, and/or a converter in combination with a known structure. Also, a semiconductor device according to a present disclosure may be used in a semiconductor system including a power source, to which the semiconductor device may be electrically connected by a known structure and/or method. The semiconductor device may be electrically connected to a wiring pattern in the semiconductor system.

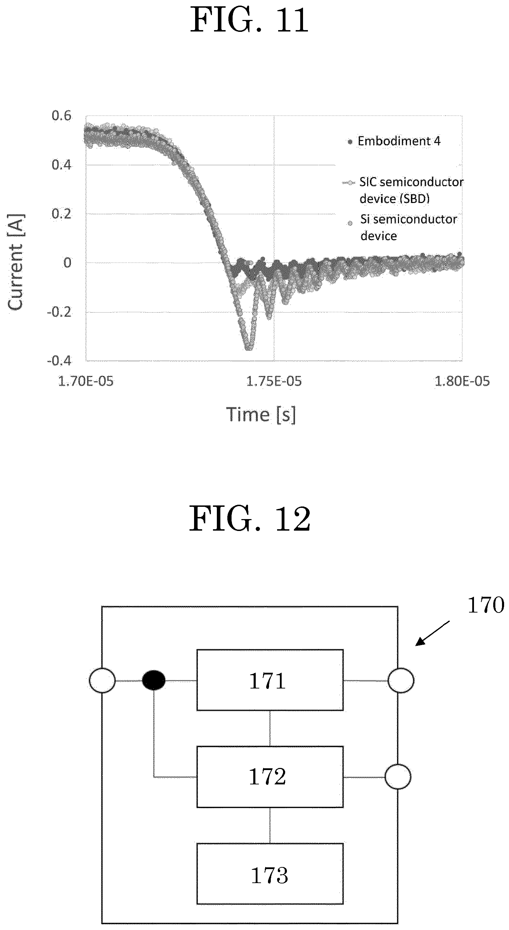

FIG. 12 shows schematic view of a semiconductor system according to an example of a present disclosure. The semiconductor system may be a power system 170. The power system 170 may include two or more power devices and a control circuit. The power system 170 shown in FIG. 12 may include a first power system 171 and a second power system 172 and a control circuit 173 that are electrically connected in the power system 170.

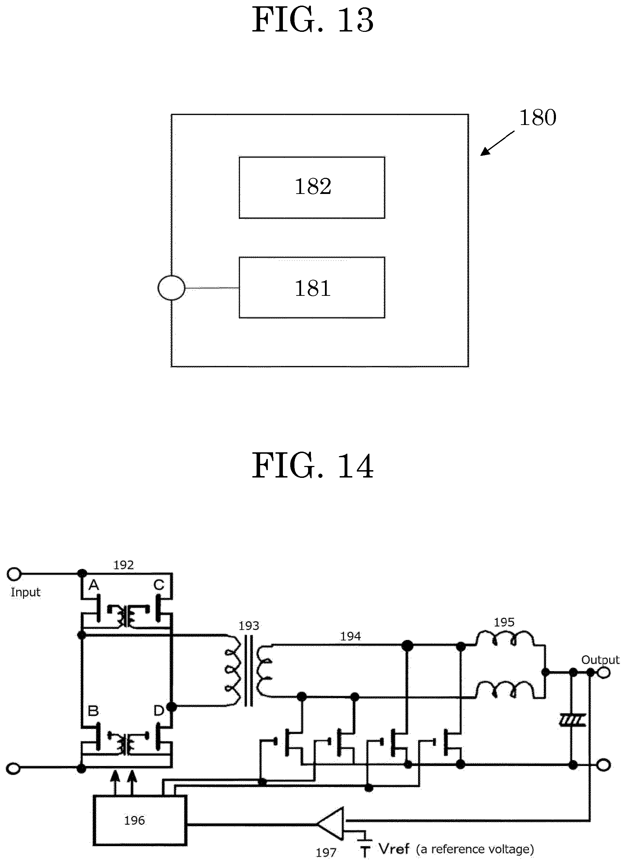

FIG. 13 shows a schematic view of a semiconductor system according to an example of a present disclosure. The semiconductor system may be a system device 180, as shown in FIG. 13. The system device 180 may include a power system 181 and an electric circuit 182 that may be combined with the power system 181.

FIG. 14 shows a schematic view of a circuit diagram of power supply of a semiconductor system according to an example of a present disclosure. FIG. 14 illustrates a power supply circuit 191 of a power supply device, including a power circuit and a control circuit. A DC voltage is switched at high frequencies by an inverter 192 (configured with MOSFET A to D) to be converted to AC, followed by insulation and transformation by a transformer 193. The voltage is then rectified by rectification MOSFETs 194 and then smoothed by a DCL 195 (smoothing coils L1 and L2) and a capacitor to output a direct current voltage. At this point, the output voltage is compared with a reference voltage by a voltage comparator 197 to control the inverter and the rectification MOSFETs by a PWM control circuit 196 to have a desired output voltage.

### (Example I)

### 1. Formation of n⁺-type Semiconductor Layer

### 1-1. Film Formation Apparatus

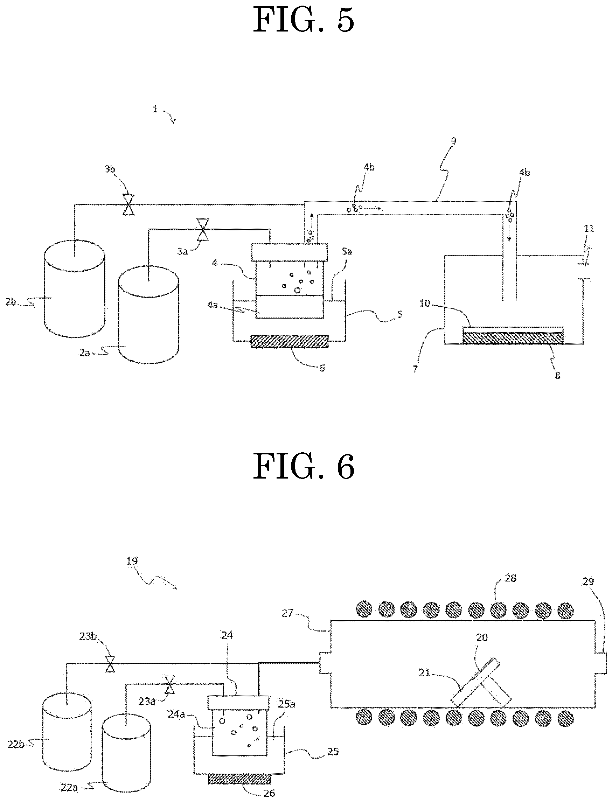

Regarding a film-formation apparatus, a mist CVD apparatus 1 used in an example of method according to a present disclosure is described below with FIG. 5. The mist CVD apparatus 1 includes a carrier gas source 2a, a first flow-control valve 3a that is configured to control a flow of carrier gas sent from the carrier gas source 2a, a diluted carrier gas source 2b, a second flow-control valve 3a that is configured to control a flow of diluted carrier gas sent from the diluted carrier gas source 2b, a mist generator 4 containing a raw material solution 4a, a container 5 containing water 5a, an ultrasonic transducer 6 attached to a bottom of the container 5, a film-formation chamber 7, a supply pipe 9 connecting from the mist generator 4 to the film-formation chamber 7, a hot plate 8 arranged in the film-formation chamber 7, and an air duct 11 that is configured to emit mist after thermal reaction, droplets, and gas that is used. Also, a substrate 10 may be set on the hot plate 8.

### 1-2. Preparation of a Raw-Material Solution

Tin bromide was mixed to a 0.1 M aqueous gallium bromide solution, and the aqueous gallium bromide solution containing tin bromide was prepared to have an atomic ratio of tin to gallium that is 1:0.08, and at this point, deuterated hydrobromic acid (deuterium bromide in D₂O) was contained in the aqueous gallium bromide solution containing tin bromide to have a volume ratio of 10% of the aqueous solution that would be a raw-material solution.

### 1-3. Film Formation Preparation

The raw-material solution 4a obtained at 1-2. the Preparation of the Raw-Material Solution was set in the mist generator 4. Then, a sapphire substrate was placed on the hot plate 8 as a substrate 10, and the hot plate 8 was activated to raise the temperature in the film-formation chamber 7 up to 470°C. The first flow-control valve 3a and the second flow-control valve 3b were opened to supply a carrier gas from the carrier gas source 2a and the diluted carrier gas source 2b, which are the source of carrier gas, into the film-formation chamber 7 to replace the atmosphere in the film-formation chamber 7 with the carrier gas sufficiently. After the atmosphere in the film formation chamber 7 was sufficiently replaced with the carrier gas, the flow rate of the carrier gas from the carrier gas source 2a was regulated at 5.0 L/min. and the diluted carrier gas from the diluted carrier gas source 2b was regulated at 0.5 L/min. In this example, nitrogen was used as the carrier gas.

### 1-4. Formation of a film that is a crystalline oxide semiconductor film

The ultrasonic transducer 6 was then vibrated at 2.4 MHz, and the vibration propagated through the water 5a to the raw material solution 4a to atomize the raw material solution 4a to form a mist 4b. The mist 4b was sent through a supply pipe 9 with the carrier gas and introduced in the film formation chamber 7. The mist was thermally reacted at 470°C under atmospheric pressure in the film formation chamber 7 to form a film on the substrate 10. The film that was obtained was a crystalline oxide semiconductor film with a thickness of 7.5 µm. The film formation time was 180 minutes.

### 1-5. Evaluation

Using an X-ray diffraction (XRD) device, a phase of the film obtained at 1-4 the formation of the film described above was identified as α-Ga₂O₃. The semiconductor film obtained in this example may be used as a semiconductor layer in a semiconductor device. The semiconductor layer may include a surface area that is 3 mm² or less.

### 2. Formation of n⁻-type Semiconductor Layer

### 2-1. Film Formation Apparatus

Regarding a film-formation apparatus, a mist CVD apparatus 19 used in an example method according to a present disclosure is described with FIG. 6. The mist CVD apparatus 19 may include a susceptor 21 on which a substrate 20 is placed. The mist CVD apparatus 19 includes a carrier gas supply device 22a, a first flow-control valve 23a to control a flow of a carrier gas that is configured to be sent from the carrier gas supply device 22a, a diluted carrier gas supply device 22b, a second flow-control valve 23b to control a flow of a carrier gas that is configured to be sent from the carrier gas supply device 22b, a mist generator 24 in that a raw material solution 24a is contained, a container 25 in that water 25a is contained, an ultrasonic transducer that may be attached to a bottom surface of the container 25, a supply pipe 27 that may be a quartz pipe with an inside diameter that may be 40 mm, and a heater 28 arranged at a peripheral portion of the supply pipe. The susceptor 21 includes a surface that is slanted off the horizontal and on that the substrate 20 is arranged. The susceptor 21 is made of quartz. Since the susceptor 21 and the supply pipe 27 that are configured to be a film-formation chamber are made of quartz, this configuration reduces a possibility that a foreign substance entering a film that is formed on the substrate 20.

### 2-2. Preparation of a Raw-Material Solution

Deuterium bromide acid was contained at a volume ratio of 20% in a 0.1 M aqueous gallium bromide solution to make a raw-material solution.

### 2-3. Film Formation Preparation

The raw-material solution 24a obtained at 2-2. the Preparation of the Raw-Material Solution above was set in the mist generator 24. Then, an n⁺-type semiconductor film that was separated from a sapphire substrate was placed on the susceptor 21, and the heater 28 was activated to raise the temperature in the film-formation chamber 27 up to 510°C. The first flow-control valve 23a and the second flow-control valve 23b were opened to supply a carrier gas from the carrier gas source 22a and the diluted carrier gas source 22b, which are the source of carrier gas, into the film-formation chamber 27 to replace the atmosphere in the film-formation chamber 27 with the carrier gas sufficiently. After the atmosphere in the film formation chamber 27 was sufficiently replaced with the carrier gas, the flow rate of the carrier gas from the carrier gas source 22a was regulated at 5.0 L/min. and the diluted carrier gas from the diluted carrier gas source 22b was regulated at 0.5 L/min. In this example, oxygen was used as the carrier gas.

### 2-4. Formation of a film that is a crystalline oxide semiconductor film

The ultrasonic transducer 26 was then vibrated at 2.4 MHz, and the vibration propagated through the water 25a to the raw material solution 24a to atomize the raw material solution 24a to form a mist. The mist was introduced in the film formation chamber 27 with the carrier gas. The mist was thermally reacted at 510°C under atmospheric pressure in the film formation chamber 27 to form a film on the substrate 20. The film that was obtained was a crystalline oxide semiconductor film with a thickness of 3.6 µm. The film formation time was 120 minutes.

### 2-5. Evaluation

Using an X-ray diffraction (XRD) device, a phase of the film obtained at 2-4 the formation of the film described above was identified as α-Ga₂O₃. The semiconductor film obtained in this example may be used as a semiconductor layer in a semiconductor device. The semiconductor layer may include a surface area that is 3 mm² or less.

### 3. Formation of a First Metal Layer (Schottky Electrode)

As shown in Fig. 3, on an n⁻-type semiconductor layer, a Pt layer, a Ti layer, and an Au layer were laminated respectively by electron beam evaporation. The Pt layer had a thickness of 10 nm, the Ti layer had a thickness of 4 nm, and the Au layer had a thickness of 175 nm.

### 4. Formation of a Second Metal Layer (Ohmic Electrode)

As shown in Fig. 4, on an n⁺-type semiconductor layer, a Ti layer and an Au layer were laminated respectively by electron beam evaporation. The Ti layer had a thickness of 35 nm and the Au layer had a thickness of 175 nm.

### 5. Current-Voltage (IV) Measurement

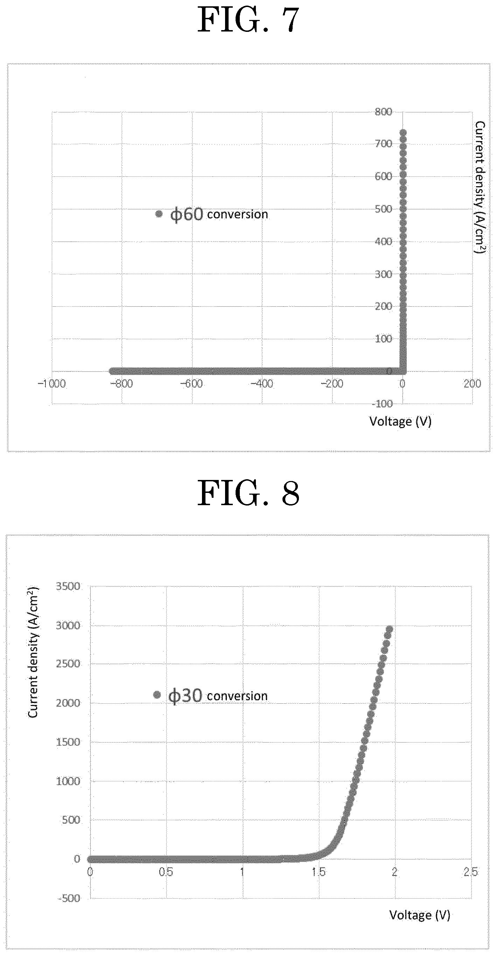

The semiconductor device obtained by the above-mentioned method was subjected to IV measurement, and the measurement result is shown in FIG. 7. The withstand voltage that was checked was found to be 855 V Accordingly, the measurement results suggested that the semiconductor device was enhanced in semiconductor characteristics.

### (Example II)

A semiconductor device was obtained by a method similarly to the method to obtain the semiconductor device in Example I except the following conditions: the film formation temperature was set to be 525°C during formation of the n⁻-type semiconductor layer, and the film formation time was set to be 20 minutes.
The n⁻-type semiconductor layer had a thickness that was 0.5 µm. The semiconductor device obtained in Example II was subjected to IV measurement, and the measurement result is shown in FIG. 8. The on-resistance (differential resistance) that was checked was 0.11 mΩcm². The semiconductor device in this example may include a semiconductor layer including a surface area that is 3 mm² or less.

### (Example III)

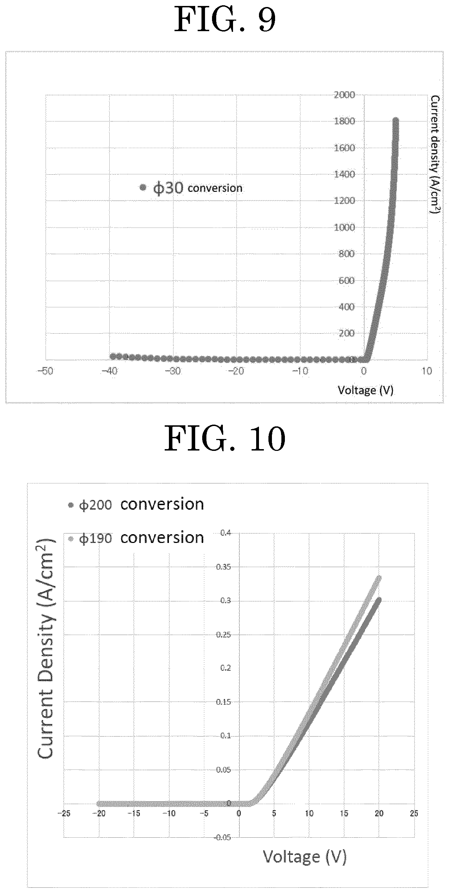

A semiconductor device was obtained by a method similarly to the method to obtain the semiconductor device in Example I except the following conditions: (1) during the film formation to obtain an n⁻-type semiconductor layer, deuterium bromide acid at a volume ratio of 15% was contained in the raw-material solution and the film formation time was set to be 8 hours, (2) the film formation temperature was set to be 500°C during the film formation to obtain an n⁺-type semiconductor layer, and the film formation time was set to be 110 minutes, and (3) during formation of the first metal layer (Schottky electrode), a Ti layer and an Au layer were laminated on the n-type semiconductor layer respectively by electron beam evaporation. The semiconductor device obtained in Example III was subjected to IV measurement, and the measurement result is shown in Fig. 9. Fig. 9 clearly shows that the semiconductor device was enhanced in semiconductor characteristics. The on-resistance (differential resistance) that was checked was 0.11 mΩcm². The semiconductor device in this example may include a semiconductor layer including a surface area that is 3 mm² or less.

### (Comparative example)

For reference, IV measurement results of a semiconductor device are shown in FIG. 10 in condition that Pt was used for the Schottky electrode in the semiconductor device. Fig. 10 shows that the semiconductor device including a Schottky electrode that is made of Pt tends to be inferior to the semiconductor devices obtained in Example I and III, for example.

### (Example IV)

### 1. Formation of n⁻-type semiconductor layer

### 1-1. Film Formation Apparatus

With reference to Fig. 5, a mist CVD apparatus 1 used in examples of a present disclosure is described. The mist CVD apparatus 1 includes a carrier gas source 2a to supply a carrier gas, a first flow-control valve 3a that is configured to control a flow of carrier gas sent from the carrier gas source 2a, a diluted carrier gas source 2b to supply a carrier gas, a second flow-control valve 3a that is configured to control a flow of diluted carrier gas sent from the diluted carrier gas source 2b to supply a diluted carrier gas, a first flow-control valve 3a to control the flow of the carrier gas from the carrier gas source 2a, a second flow-control valve 3b to control the flow of the diluted carrier gas from the diluted carrier gas source 2b, a mist generator 4 containing a raw material solution 4a, a container 5 containing water 5a, an ultrasonic transducer 6 attached to a bottom of the container 5, a film-formation chamber 7, a supply pipe 9 connecting from the mist generator 4 to the film-formation chamber 7, a hot plate 8 arranged in the film-formation chamber 7, and an air duct 11 that is configured to emit mist after thermal reaction, droplets, and gas that is used. Also, a substrate 10 may be set on the hot plate 8.

In examples of a present disclosure, as a substrate 10, a sapphire substrate containing an Sn-doped α-Ga₂O₃ layer formed on a surface of the sapphire substrate as a buffer layer was used. The sapphire substrate including grooves with a groove gap (pitch) that is 1mm and with a groove depth that is 30 µm was used. The grooves of the sapphire substrate were formed in the sapphire substrate to form square grids by a laser machine of YVO4 laser (with wavelength of 532 nm and average output that is 4 W).

### 1-2. Preparation of Raw-Material Solution

Hydrobromic acid was contained at a volume ratio of 10% in a 0.1 M aqueous gallium bromide solution to make a raw-material solution.

### 1-3. Film Formation Preparation

The raw-material solution 4a obtained at 1-2. above was set in the mist generator 4. As a substrate 10, a sapphire substrate with a buffer layer formed on the sapphire substrate was placed on the hot plate 8. The hot plate 8 was activated to raise a temperature in the film formation chamber 7 up to 470°C. Then, the first flow-control valve 3a and the second flow-control valve 3b were opened to supply the carrier gas from the carrier gas source 2a and the diluted carrier gas source 2b as the carrier gas source into the film formation chamber 7. After the atmosphere in the film formation chamber 7 was sufficiently replaced with the carrier gas, the flow of the carrier gas was set to be at 2.0 L/min. and the flow rate of the diluted carrier gas was set to be at 0.5 L/min. As the carrier gas, oxygen was used.

### 1-4. Formation of a film that is a crystalline oxide semiconductor film

The ultrasonic transducer 6 was then vibrated at 2.4 MHz, and the vibration propagated through the water 5a to the raw-material solution 4a to atomize the raw material solution 4a to form a mist. The mist was through the supply pipe 9 introduced in the film formation chamber 7 with the carrier gas. The mist 4b was thermally reacted at 470°C under atmospheric pressure in the film formation chamber 7 to form a film on the substrate 10. The film was a crystalline oxide semiconductor film with a thickness that was approximately 5 µm. The film formation time was 135 minutes.

### 1-5. Evaluation

Using an X-ray diffraction (XRD) device, a phase of the film obtained at 1-4 the formation of the film described above was identified as α-Ga₂O₃. The semiconductor film obtained in this example may be used as a semiconductor layer in a semiconductor device. The semiconductor layer may include a surface area that is 3 mm² or less.

### 2. Formation of n⁺-type semiconductor layer

### 2-1. Film Formation Apparatus

A mist CVD apparatus that was used in 1-1 was also used here in 2-1. As a substrate 10, using the film on the substrate obtained in 1-4 above, an n⁺-type semiconductor layer was laminated on the n⁻-type semiconductor layer.

### 2-2. Preparation of Raw-Material Solution

Tin bromide was mixed to a 0.1 M aqueous gallium bromide solution, and the aqueous solution was prepared to have an atomic ratio of tin to gallium of 1:0.08. At this point, deuterium bromide acid was contained at a volume ratio of 10% in the 0.1 M aqueous gallium bromide solution to make a raw-material solution.

### 2-3. Film Formation Preparation

The raw-material solution 4a obtained at 2-2. above was set in the mist generator 4. As the substrate 10, a sapphire substrate with a buffer layer was then placed on the hot plate 8. The hot plate 8 was activated to raise a temperature in the film formation chamber 7 up to 450°C. The first flow-control valve 3a and the second flow-control valve 3b were opened to supply the carrier gas from the cariier gas source 2a and the diluted carrier gas source 2b to the film formation chamber 7. After the atmosphere in the film formation chamber 7 was sufficiently replaced with the carrier gas, the flow of the carrier gas was set to be at 2.0 L/min. and the flow of the diluted carrier gas was regulated at 0.5 L/min. As the carrier gas, nitrogen was used.

### 2-4. Formation of a film that is a crystalline oxide semiconductor film

The ultrasonic transducer 6 was then vibrated at 2.4 MHz, and the vibration propagated through the water 5a to the raw-material solution 4a to atomize the raw material solution 4a to form a mist. The mist was through the supply pipe 9 introduced in the film formation chamber 7 with the carrier gas. The mist 4b was thermally reacted at 450 °C under atmospheric pressure in the film formation chamber 7 to form a film on the substrate 10. The film was a crystalline oxide semiconductor film with a thickness that was approximately 2.9 µm. The film formation time was 120 minutes.

### 2-5. Evaluation

Using an X-ray diffraction (XRD) device, a phase of the film obtained at 1-4 the formation of the film described above was identified as α-Ga₂O₃. The semiconductor film obtained in this example may be used as a semiconductor layer in a semiconductor device. The semiconductor layer may include a surface area that is 3 mm² or less.

### 3. Formation of Ohmic Electrode

On the n⁺-type semiconductor layer of the laminate that is the crystalline oxide semiconductor film on the substrate 10 obtained in 2-4. above, a Ti film (thickness of 70 nm) and an Au film (thickness of 30 nm) were formed to be an ohmic electrode.

### 4. Substrate Removal

On the ohmic electrode of the laminate obtained in 4. above, a provisional wafer was temporarily joined. Using a CMP apparatus, the substrate 10 was then polished to remove the sapphire substrate and the buffer layer.

### 5. Formation of Schottky Electrode

On the n⁻-type semiconductor layer of the laminate obtained in 5. above, a Cr film (thickness of 50 nm) and an Al film (with a thickness that is 5000 nm) were respectively formed by EB evaporation to make a Schottky electrode (with a diameter that is 300 µm). It was then packaged in a TO 220 to obtain an implemented SBD.

### 6. Evaluation of characteristics for a semiconductor device

### (Evaluation of switching characteristics)

The switching characteristics of the SBD obtained at 5. above were evaluated. Results are shown in FIG. 11, and as a comparison with the switching characteristics of the SBD, switching characteristics of a semiconductor device using SiC and switching characteristics of a semiconductor device using Si were also shown in FIG. 11. Accordingly, FIG. 11 shows that the SBD obtained at 5. according to an example of a present disclosure is superior in switching characteristics to the semiconductor device using SiC and the semiconductor device using Si.

### (Thermal Resistance Property Evaluation)

The SBD obtained in 5. above was measured to check a thermal resistance. As a result, the SBD obtained in 5. had Rjc that is 13.9°C/W, which was equivalent to or higher in performance than that (Rjc = 12.5°C/W) of the semiconductor device using SiC. Considering the area of the SBD and the semiconductor devices using SiC, the SBD according to an example of a present disclosure is able to be downsized up to approximately 60% to exhibit an equivalent performance of the semiconductor device using SiC. is capable of exhibiting equivalent performance compared with one using SiC.

### (Capacitance Measurement)

CV measurement (1 MHz, 50mV) was done on the SBD obtained at 5. above. Accordingly, the measurement result was 130 pF at 0 V bias, and this result shows that the SBD is superior in switching characteristics to the semiconductor device using SiC, because the SBD according to an example of a present disclosure has a capacitance smaller than the semiconductor device using SiC.

### (Calculated evaluation of semiconductor devices)

A thermal resistance of a packaging portion (epoxy) of an SBD containing α-Ga₂O₃ according to an example was calculated to be around 15.6 (K/W). Also, thermal resistance of semiconductor devices containing semiconductor layers of Trial 1 containing α-Ga₂O₃, Trial 2 containing β-Ga₂O₃ and Trial 3 containing SiC shown in the Table 1 were calculated respectively, and the calculated evaluations of thermal resistance of Trial 1 and Trial 3 at the respective semiconductor layers were less than 1.5 (K/W), that was sufficiently lower than the thermal resistance of the packaging portion. The calculated evaluation of thermal resistance of Trial 2 at the semiconductor layer was more than 1.5 (K/W). The Table 1 shows that the semiconductor layer of Trial 1 that contains α-Ga₂O₃ even with a smaller surface area may be expected to have a sufficiently small thermal resistance. Accordingly, a semiconductor device including a semiconductor layer containing α-Ga₂O₃ may be expected to be downsized. The semiconductor layer of the semiconductor device according to this example of a present disclosure includes a surface area that is 3 mm² or less.

**[Table 1]**

| | Semiconductor Layer | | |
|---|---|---|---|
| | Type Of Semiconductor | Thickness Of Semiconductor Layer (mm) | Size (mm square) |
| Trial 1 | α-Ga₂O₃ | 0.01 | 0.8 |
| Trial 2 | β-Ga₂O₃ | 0.2 | 0.8 |
| Trial 3 | SiC | 0.3 | 1.6 |

### (Example V)

Another SBD was obtained by a method similarly to the method to obtain the SBD that was obtained at Example IV above except the diameter of the Schottky electrode. The SBD in Example V includes a Schottky electrode with a diameter that is 500 µm, while the SBD that was obtained at Example IV above had a diameter that was 300 µm.
The switching characteristics of the SBD in Example V were evaluated and found to have a similar waveform to that of the SBD that was obtained at 5. had. Accordingly, the SBD in Example V is found to have good switching characteristics.

A semiconductor device according to an example of a present disclosure is applicable as semiconductor devices (e.g., compound semiconductor devices) and electronic components and electronic devices, optical and electronic photography related devices, and industrial parts. A semiconductor device according to an example of a present disclosure is useful for power devices.

The semiconductor film obtained in this example may be used as a semiconductor layer in a semiconductor device. The semiconductor layer may include a surface area that is 3 mm² or less.

### (Example VI)

A semiconductor device according to an example of a present disclosure may include a semiconductor layer with a dielectric breakdown field that is 6 MV/cm or more.

Gallium oxide (Ga₂O₃) has five crystal structures of α, β, γ, δ, and ε, and generally it is said that β-Ga₂O₃ has the most stable structure. However, since β-Ga₂O₃ has a β-gallia structure, that is unique and different from crystal systems generally used in electronic materials, β-Ga₂O₃ is not always suitable to be used in semiconductor devices.

In contrast, α-Ga₂O₃ having a crystal structure same as that of a sapphire substrate that has been industrially used appears to be suitable to be α-Ga₂O₃ be used in optical and/or electronic devices. Also, α-Ga₂O₃ has a band gap wider than that of β-Ga₂O₃, and thus, α-Ga₂O₃ is useful for a material of semiconductor devices, especially for power devices.

Accordingly, a semiconductor device according to an example of a present disclosure includes a semiconductor layer that includes an oxide semiconductor as a major component, the semiconductor layer with a dielectric breakdown field that is 6MV/cm or more. The oxide semiconductor of the semiconductor layer may be a crystalline oxide semiconductor that contains a β-gallia structure or a corundum structure, however, a crystalline oxide semiconductor containing a corundum structure is preferable in this example.

Also, a crystalline oxide semiconductor layer according to an example of a present disclosure, the crystalline oxide semiconductor layer preferably contains an InAlGaO-based semiconductor. The crystalline oxide semiconductor layer may contain gallium or indium. The crystalline oxide semiconductor layer may preferably contain gallium. A crystalline oxide semiconductor containing at least gallium may contain α-Ga₂O₃ or a mixed crystal of α-Ga₂O₃.

The semiconductor device in this example includes a semiconductor layer including a crystalline oxide semiconductor that contains gallium as a major component.

The term "major component" herein means, for example, in a case that a crystalline oxide semiconductor of a crystalline oxide semiconductor layer is α-Ga₂O₃, an atomic ratio of gallium in a metal element in the crystalline oxide semiconductor layer may be 0.5 or more.

According to an example of a present disclosure, the atomic ratio of gallium in a metal element in a crystalline oxide semiconductor layer may be preferably 0.7 or more. For a present disclosure, the atomic ratio of gallium in a metal element in a crystalline oxide semiconductor layer may be further preferably 0.8 or more.

Furthermore, the thickness of the crystalline oxide semiconductor layer may not be particularly limited herein. However, the thickness of a crystalline oxide semiconductor layer according to an example of a semiconductor device of a present disclosure may be 1 µm or less. Also, the thickness of the crystalline oxide semiconductor layer according to an example of a semiconductor device of a present disclosure may be 1 µm or more. Especially in this example, the thickness of a crystalline oxide semiconductor layer may be preferably 40 µm or less. According to an example, the thickness of the crystalline oxide semiconductor layer may be preferably 25 µm or less. Also, according to an example, the thickness of the crystalline oxide semiconductor layer may be preferably 12 µm or less and may be further preferably 8 µm or less.

In this example of a semiconductor device of a present disclosure, the semiconductor layer may include a surface area that is 3 mm² or less. Also, according to an example of a present disclosure, the semiconductor layer may include a surface area that is in a range of 3 mm² or less to 1 mm² or more. Furthermore, according to an example of a present disclosure, the semiconductor layer may include a surface area that is 1 mm² or less. The semiconductor layer that is a crystalline semiconductor layer may include a single crystal according to an example. Also, the semiconductor layer that is a crystalline semiconductor layer may be polycrystalline. Also, the semiconductor layer that is a crystalline semiconductor layer is a single layer, according to an example of a present disclosure.

Furthermore, the semiconductor layer that is a crystalline semiconductor layer may include two or more layers, according to an example of a present disclosure.

A semiconductor device according to an example of a present disclosure includes a semiconductor layer including a first semiconductor layer and a second semiconductor layer. The first semiconductor layer may include a crystalline oxide semiconductor containing gallium. Also, the second semiconductor layer may include a crystalline oxide semiconductor containing gallium.

The first semiconductor layer with a first thickness and the second semiconductor layer with a second thickness are 40 µm or less as a total thickness of the first thickness of the first semiconductor layer and the second thickness of the second semiconductor layer. At least one of the first semiconductor layer and the second semiconductor layer may include a surface area that is 3 mm² or less.

The semiconductor device further includes a Schottky electrode that may be positioned on the first semiconductor layer. If the Schottky electrode is arranged on the first semiconductor layer, the first semiconductor layer contains a first carrier concentration that is smaller than a second carrier concentration contained in the second semiconductor layer. In this example, the second semiconductor layer may contain a dopant, and the carrier concentration of the semiconductor layer may be set by adjusting a quantity of the dopant.

Also, according to an example of a present disclosure, a crystalline oxide semiconductor layer may contain a dopant. As an n-type dopant, for example, tin, germanium, silicon, titanium, zirconium, vanadium, or niobium may be suggested. However, a dopant is not limited thereto, and the dopant may be a known one, and the dopant may include an n-type dopant and/or a p-type dopant.

Also, it is noted that impurities may be contained in a crystalline oxide semiconductor layer during a film-formation process, for example, and may function as a dopant.

If the first semiconductor layer contains a dopant, the content of dopant in composition of the first semiconductor layer may be 0.0000000001 atom% or more. Also, if the first semiconductor layer contains a dopant, the content of dopant in composition of the first semiconductor layer may be preferably in a range of 0.0000000001 atom% to 20 atom%, according to an example of a present disclosure. Furthermore, if the first semiconductor layer contains a dopant, the content of dopant in composition of the first semiconductor layer may be further preferably in a range of 0.0000000001 atom% to 1 atom%, according to an example of a present disclosure.

Also, for example, if the second semiconductor layer contains a dopant, the content of dopant in composition of the second semiconductor layer may be 0.0000001 atom% or more. Also, if the second semiconductor layer contains a dopant, the content of dopant in composition of the second semiconductor layer may be preferably in a range of 0.0000001 atom% to 20 atom%, according to an example of a present disclosure. Furthermore, if the second semiconductor layer contains a dopant, the content of dopant in composition of the second semiconductor layer may be further preferably in a range of 0.0000001 atom% to 10 atom%, according to an example of a present disclosure.

If the content of dopant in composition of the crystalline oxide semiconductor film becomes in a range that is preferable or further preferable, the crystalline oxide semiconductor film or a crystalline oxide semiconductor layer that is arranged in a semiconductor device would be more enhanced in electrical characteristics.

The semiconductor layer including the first semiconductor layer and the second semiconductor layer is obtainable, for example, by atomization and/or forming droplets of a raw material solution at the atomization and/or forming droplets process as mentioned below, carrying mist and/or droplets to be delivered into a film-formation chamber by carrier gas at the carrying mist and/or droplets process as mentioned below, and a crystallinity oxide semiconductor layer is formed on a crystalline substrate by thermal reaction of the mist and/or droplets of the raw material solution at the film-formation process as mentioned below.

### (Atomization and/or forming droplets process)

At the atomization and/or forming droplets process, the raw material solution may be atomized and/or droplets of the raw material solution may be formed. A method to atomize the raw material solution and/or to form droplets of the raw material solution is not limited herein. The method to atomize the raw material solution and/or to form droplets of the raw material solution may be a known method if the raw material solution is able to be atomized and/or formed into droplets.

According to an example of the present disclosure, atomizing the raw material solution by ultrasonic waves to obtain mist and/or forming droplets from the raw material solution by ultrasonic waves is preferable. The mist or droplets obtained using ultrasonic waves have an initial rate of zero to be suspended in the air. The mist obtained using ultrasonic waves is capable of being suspended in a space to be delivered as a gas, is not blown like a spray, for example, and thus, is not damaged by collision energy. Accordingly, the mist obtained using ultrasonic waves is preferable. The size of droplet may not be particularly limited and a droplet may be of approximately several mm, however, according to an example of a present disclosure, the size of droplet may be 50 µm or smaller. Also, according to an example of a present disclosure, the size of droplet may be in a range of 0.1 µm to 10 µm.

### (Raw material solution)

If the raw material solution contains a material that is able to be atomized and/or to be formed into droplets, and if the raw material solution contains a deuterium, the material is not particularly limited, and thus may contain an inorganic material and/or an organic material. However, according to an example of a present disclosure, the material in the raw material solution may be a metal and/or a metal compound. The material in the raw material solution may include one or more metals selected from gallium, iron, indium, aluminum, vanadium, titanium, chromium, rhodium, nickel, cobalt, zinc, magnesium, calcium, silicon, yttrium, strontium, and barium.

According to an example of a present disclosure, a raw-material solution containing at least one metal, in the form of complex or salt, dissolved or dispersed in an organic solvent or water may be used. Examples of the form of the complex may include acetylacetonate complexes, carbonyl complexes, ammine complexes, hydride complexes. Also, examples of the form of the salt may include organic metal salts (e.g., metal acetate, metal oxalate, metal citrate, etc.), metal sulfide salt, metal nitrate salt, metal phosphate salt, metal halide salt (e.g., metal chloride salt, metal bromide salt, metal iodide salt, etc.).

The raw-material solution, may contain hydrohalic acid and/or an oxidant as an additive. Examples of the hydrohalic acid may include hydrobromic acid, hydrochloric acid, hydriodic acid. Among all, hydrobromic acid or hydroiodic acid may be preferable for a reason to obtain a film of better quality. Also, examples of the oxidant include peroxides that include hydrogen peroxide (H₂O₂), sodium peroxide (Na₂O₂), barium peroxide (BaO₂), and benzoyl peroxide (C₆H₅CO)₂O₂, hypochlorous acid (HClO), perchloric acid, nitric acid, ozone water, and organic peroxides that include peracetic acid and nitrobenzene.

The raw-material solution may contain a dopant, which is used to produce a desired electrical characteristic in a semiconductor. Examples of the dopant may include n-type dopants. The n-type dopants may include tin, germanium, silicon, titanium, zirconium, vanadium, and niobium. Also, examples of the dopant may include p-type dopants, and the dopant may not be particularly limited as long as an object of a present disclosure is not interfered with. The dopant concentration in general may be in a range of 1×10¹⁶/cm³ to 1×10²²/cm³. The dopant concentration may be at a lower concentration of, for example, approximately 1×10¹⁷/cm³ or less. According to an example of the present disclosure, the dopant may be contained at a high concentration of, for example, 1×10²/cm³ or more. According to a semiconductor device of this example of a present disclosure, the dopant concentration in the raw-material solution is preferably 1×10¹⁷/cm³ or more.

A solvent of the raw-material solution is not particularly limited, and thus, the solvent may be an inorganic solvent that include water. The solvent may be an organic solvent that includes alcohol. The solvent may be a mixed solvent of the inorganic solvent and the organic solvent. According to an example of a present disclosure, the solvent contains water. Also, according to an example of a present disclosure, the solvent may be a mixed solvent of water and alcohol.

### (Carrying mist and/or droplets process)

At the process for carrying mist and/or droplets, the mist and/or droplets are delivered into a film-formation chamber by carrier gas. The carrier gas is not limited as long as an object of a present disclosure is not interfered with, and thus, the carrier gas may be an inert gas such as oxygen, ozone, nitrogen, and argon. Also, the carrier gas may be a reducing gas that may be a hydrogen gas and/or a forming gas. The carrier gas may contain one or two or more gasses. Also, a diluted carrier gas at a reduced flow rate (e.g., 10-fold diluted carrier gas) and the like may be used further as a second carrier gas. The carrier gas may be supplied from one or more locations. While the flow rate of the carrier gas is not particularly limited, the flow rate of the carrier gas may be in a range of 0.01 to 20 L/min. According to an example of the disclosure, the flow rate of the carrier gas may be preferably in a range of 1 to 10 L/min. When a diluted carrier gas is used, the flow rate of the diluted carrier gas may be in a range of 0.001 to 2L/min. Furthermore, according to an example of an disclosure, when a diluted carrier gas is used, the flow rate of the diluted carrier gas may be in a range of 0.1 to 1L/min.

### (Film Formation Process)

At the film-formation process, a crystallinity oxide semiconductor layer is formed on a crystalline substrate by thermal reaction of the mist and/or droplets of the raw material solution. The term "thermal reaction" herein includes just a reaction of the mist and/or droplets by heat. Conditions of reaction are not particularly limited only if an object of a present disclosure is not interfered with. In the film-formation process, the thermal reaction is conducted at an evaporation temperature or higher temperature of the evaporation temperature of the solvent of the raw material solution. During the thermal reaction, the temperature should not be too high. For example, the temperature during the thermal reaction may be 1000 °C or less. The temperature during the thermal reaction is preferably 650 °C or less. According to an example of the present disclosure, the temperature during the thermal reaction is further preferably in a range of 350 °C to 650 °C. Also, the thermal reaction may be conducted in any atmosphere of a vacuum, a non-oxygen atmosphere, a reducing-gas atmosphere, and an oxygen atmosphere. Also, the thermal reaction may be conducted in any condition of under an atmospheric pressure, under an increased pressure, and under a reduced pressure. According to an example of a present disclosure, the thermal reaction is preferably conducted under an atmospheric pressure. Also, a film thickness of crystalline oxide semiconductor film is able to be set by adjusting a film-formation time.

### (A substrate)

A substrate is not particularly limited as long as it is capable of supporting a crystalline oxide semiconductor film. The material for the substrate is also not particularly limited as long as an object of the present invention are not interfered with, and the substrate may be a substrate of a known material. Also, the substrate may contain an organic compound and/or an inorganic compound.

Also, the substrate may be in any shape and may be valid for all shapes. Examples of the shape of the substrate include a plate shape, a flat plate shape and a disk shape, a fibrous shape, a rod shape, a cylindrical shape, a prismatic shape, a tubular shape, a spiral shape, a spherical shape, and a ring shape. According to an example of a present disclosure, a substrate may be selected and the thickness of the substrate may not be particularly limited.

Furthermore, a material for the substrate is not particularly limited as long as an object of the present disclosure is not interfered with, and also, the material may be a known one. A substrate with a corundum structure would be a substrate material for an example of a present disclosure. Examples of a substrate with a corundum structure include α-Al₂O₃ (sapphire substrate) and α-Ga₂O₃. Also, according to an example of a present disclosure, the substrate may be an a-plane sapphire substrate, an m-plane sapphire substrate, an r-plane sapphire substrate, a c-plane sapphire substrate, an α gallium oxide substrate (a-plane, m-plane, or r-plane), and the like. Furthermore, examples of the substrate contain a substrate material with a β-gallia structure as a major component include a β-Ga₂O₃ substrate, a mixed crystal substrate containing Ga₂O₃ and Al₂O₃, where Al₂O₃ is more than 0 wt% and 60 wt% or less, and the like. Examples of the substrate containing the substrate material with a hexagonal structure as a major component include an SiC substrate, a ZnO substrate, a GaN substrate, and the like. A metal used for the substrate material is not particularly limited while metal used for a first metal layer or a second metal layer may be selected.

According to an example of a present disclosure, a substrate may contain a metal or a corundum structure in all or part of a surface of the substrate. When the substrate contains a corundum structure, the substrate may be preferably a base substrate containing a substrate material with a corundum structure as a major component. The substrate may be preferably a sapphire substrate. The substrate may be preferably an α gallium oxide substrate. The substrate may contain aluminum, and in this case, the substrate preferably contains a substrate material containing an aluminum with a corundum structure as a major component. The substrate is preferably a sapphire substrate (preferably, a c-plane sapphire substrate, an a-plane sapphire substrate, an m-plane sapphire substrate, or an r-plane sapphire substrate). Also, the substrate may contain oxide. Examples of oxide substrate include a YSZ substrate, an MgAl₂O₄ substrate, a ZnO substrate, an MgO substrate, an SrTiO₃ substrate, an Al₂O₃ substrate, a quartz substrate, a glass substrate, a β gallium oxide substrate, a barium titanate substrate, a strontium titanate substrate, a cobalt oxide substrate, a copper oxide substrate, a chromium oxide substrate, an iron oxide substrate, a Gd₃Ga₅O₁₂ substrate, a potassium tantalate substrate, a lanthanum aluminate substrate, a lanthanum strontium aluminate substrate, a lanthanum strontium gallate substrate, a lithium niobate substrate, a tantalate lithium substrate, lanthanum strontium aluminum tantalate, a manganese oxide substrate, a neodymium gallate substrate, a nickel oxide substrate, a scandium magnesium aluminate substrate, strontium oxide, a strontium titanate substrate, a tin oxide substrate, a tellurium oxide substrate, a titanium oxide substrate, a YAG substrate, a yttrium aluminate substrate, a lithium aluminate substrate, a lithium gallate substrate, a LAST substrate, a neodymium gallate substrate, a yttrium orthovanadate substrate, and the like.

According to an example of a present disclosure, after the film formation process, annealing may be performed. The annealing temperature may not be particularly limited as long as an object of a present disclosure is not interfered with. The annealing temperature may be generally from 300°C to 650°C. According to an example of a present disclosure, the annealing temperature may be preferably from 350°C to 550°C. Also, the annealing time is generally from 1 minute to 48 hours. According to an example of a present disclosure, the annealing time may be preferably from 10 minutes to 24 hours, and further preferably from 30 minutes to 12 hours. The annealing may be performed in any atmosphere as long as an object of a present disclosure is not interfered with. The annealing may be performed in a non-oxygen atmosphere. Also, the annealing may be performed in a nitrogen atmosphere.

According to an example of a present disclosure, a crystalline oxide semiconductor film or a crystalline oxide semiconductor layer may be provided directly on a substrate or may be provided on another layer, such as a buffer layer and a stress relief layer, positioned above or below the substrate.

Layers including a crystalline oxide semiconductor layer may not be particularly limited, and thus, may be formed by a known method. However, a crystalline oxide semiconductor film may be preferably formed by a mist CVD (Chemical Vapor Deposition) apparatus.

According to an example of a present disclosure, a crystalline oxide semiconductor film may include a substrate as a crystalline oxide semiconductor layer, which may be used in a semiconductor device.

Also, according to an example of a present disclosure, a crystalline oxide semiconductor film does not include a substrate. A crystalline oxide semiconductor film that is separated from a substrate by use of a known method may be used as a semiconductor layer in a semiconductor device.

The semiconductor device includes at least a semiconductor layer that includes a crystalline oxide semiconductor and a Schottky electrode that is positioned on the semiconductor layer.

The Schottky electrode is not particularly limited as long as the Schottky electrode contains at least one metal selected from the fourth to ninth groups of the periodic table. Examples of the metal of the fourth group of the periodic table include titanium (Ti), zirconium (Zr), and hafnium (Hf). According to an example of a present disclosure, Ti may be selected as a metal used for the Schottky electrode. Examples of the metal of the fifth group of the periodic table include vanadium (V), zirconium (Zr), and hafnium (Hf). Examples of the metal of the sixth group of the periodic table include one or more metals selected from chromium (Cr), molybdenum (Mo), and tungsten (W). According to an example of a present disclosure, Cr that is expected to enhance switching characteristics of semiconductor device may be selected as a metal used for the Schottky electrode. Examples of the metal of the seventh group of the periodic table include manganese (Mn), technetium (Tc), and rhenium (Re). Examples of the metal of the eighth group of the periodic table include iron (Fe), ruthenium (Ru), and osmium (Os). Examples of the metal of the ninth group of the periodic table include cobalt (Co), rhodium (Rh), iridium (Ir). According to an example of a present disclosure, and as long as an object of a present disclosure is not interfered with, the Schottky electrode may contain a metal selected from the tenth group and the eleventh group of the periodic table. Examples of the metal of the tenth group of the periodic table include nickel (Ni), palladium (Pd), and platinum (Pt). Among all in the tenth group of the periodic table, platinum (Pt) may be selected. Examples of the metal of the eleventh group of the periodic table include copper (Cu), silver (Ag), and gold (Au). Among all in the eleventh group of the periodic table, gold (Au) may be selected.

According to an example of a present disclosure, to obtain better semiconductor properties such as switching characteristics, at least one metal is selected from the fourth group, the fifth group and the sixth group in the periodic table. Also, according to an example of a present disclosure, the Schottky electrode may contain at least one metal selected from the fourth group, the fifth group, and the sixth group in the periodic table. Furthermore, the Schottky electrode may contain a transition metal selected from the fourth group in the periodic table.

The Schottky electrode may be a metal layer of a single layer. The Schottky electrode may contain two or more metal layers and/or metal films. The two or more metal layers and/or metal films may be arranged by a method such as vacuum deposition and sputtering. Also, the two or more metal layers and/or metal films may be arranged by a known method, and not particularly limited to a particular method. Also, the Schottky electrode may include an alloy.

According to an example of a present disclosure, the Schottky electrode may contain Ti. Also, according to an example of a present disclosure, the Schottky electrode may preferably contain Au and/or Pt. A Schottky electrode containing a metal that is preferable would enhance semiconductor properties of a semiconductor device, and the semiconductor properties may include durability, dielectric breakdown voltage, withstand voltage, on-resistance, and stability.

According to an example of a present disclosure, the Schottky electrode may have a surface area that is 1 mm² or less. The Schottky electrode may preferably have a surface area that is 0.8 mm² or less.

According to an example of a present disclosure, a semiconductor device includes an ohmic electrode. The ohmic electrode may contain a metal selected from the fourth group and the eleventh group of the periodic table. The ohmic electrode may contain a same metal as a metal that is contained in a Schottky electrode. Also, the ohmic electrode may be a metal layer of a single layer or may contain two or more metal layers, which may be formed by a known method such as vacuum deposition and/or sputtering, and thus a method forming an electrode is not particularly limited. The ohmic electrode may include an alloy. According to an example of a present disclosure, the ohmic electrode may contain Ti and/or Au. The ohmic electrode may preferably contain Ti and Au.

According to an example of a present disclosure, the semiconductor device may be particularly useful for a power device. Examples of the semiconductor device according to a present disclosure include a semiconductor laser, a diode, a transistor (e.g., MESFET, etc.), and Schottky barrier diode (SBD) just for example.

### (SBD)

FIG. 1 shows a schematic view of a first example of a semiconductor device according to a present disclosure. In this example, the semiconductor device may be a Schottky barrier diode (SBD). The SBD shown in FIG. 1 includes an n⁻-type semiconductor layer 101a, an n⁺-type semiconductor layer 101b, a Schottky electrode 105a, and an ohmic electrode 105b.

Electrodes such as Schottky electrode and ohmic electrode may be formed by a known method, such as vacuum deposition and sputtering, for example. More specifically, for example, the Schottky electrode may be formed by laminating a first metal layer and patterning in the first metal layer using photolithography.

According to an example of a present disclosure, a semiconductor device includes a Schottky electrode 105a as a first metal layer and an ohmic electrode 105b as a second metal layer.

When a reverse bias is applied to an SBD shown in Fig. 1, for example, a depletion layer (not shown) will expand in the n-type semiconductor layer 101a and make the SBD have a higher breakdown voltage. When a forward bias is applied to the SBD, electrons flow from the ohmic electrode 105b to the Schottky electrode 105a. The SBD with a higher breakdown voltage is configured to apply a large current to and expected to obtain an enhanced switching speed. It would be helpful to obtain an SBD that is reliable in characteristics as a semiconductor device.

FIG. 2 shows a schematic view of a second example of a semiconductor device according to a present disclosure. This is another example of an SBD. The SBD shown in FIG. 2 includes an n⁻-type semiconductor layer 101a, an n⁺-type semiconductor layer 101b, a Schottky electrode 105a, and an ohmic electrode 105b, and the insulating layer 104.

Examples of the material for the insulating layer 104 include GaO, AlGaO, InAlGaO, AlInZnGaO₄, AlN, Hf₂O₃, SiN, SiON, Al₂O₃, MgO, GdO, SiO₂, and/or Si₃N₄. Regarding a present disclosure, the material for the insulating layer 104 may preferably contain an insulating material with a corundum structure. The insulating layer 104 containing the corundum structure reveals semiconductor characteristics effectively at an interface. The insulating layer 104 is provided between the n⁻-type semiconductor layer and the Schottky electrode 105a. The insulating layer 104 may be formed by a known method, such as sputtering, vacuum deposition, and CVD, for example.

The SBD shown in FIG. 2 would be better in an electrically-insulating property and current controllability, compared with the SBD shown in FIG. 1. Other configuration(s) may be the same as those of the SBD in FIG. 1.

A semiconductor device may include a semiconductor layer obtained by the processes mentioned above, the semiconductor layer with a dielectric breakdown field that is 6 MV/cm or more. The semiconductor layer may include a surface area that is 3 mm² or less.

Furthermore, if conditions that are preferable are applied to the processes to form the semiconductor layer, a dielectric breakdown field of the semiconductor layer is expected to be 10 MV/cm or more. The SBD as a semiconductor device may have a capacitance with a zero-bias voltage when measured at 1 MHz, and the capacitance may be 1000pF or less. According to an example of a semiconductor device of a present disclosure, the capacitance of the semiconductor device with a zero-bias voltage may be 500pF or less when measured at 1 MHz. Furthermore, a semiconductor device according to an example of a present disclosure, the capacitance of the semiconductor device with a zero-bias voltage may be 150pF or less.

If a semiconductor layer containing a carrier concentration that is 1×10¹⁷/cm³ or more, the on-resistance (differential resistance) that is checked usually becomes 1 mΩcm² or less. Also, the capacitance of the semiconductor device including the semiconductor layer with a zero-bias voltage when measured at 1 MHz may be 10mF/m² or less, the capacitance that is 5mF/m² or less may be preferable, and the capacitance that is 2mF/m² or less may be further preferable.

In addition, according to an example of a semiconductor device of a present disclosure, the semiconductor device may be used as a power module, an inverter, and/or a converter in combination with a known structure. Also, a semiconductor device according to a present disclosure may be used in a semiconductor system including a power source, to which the semiconductor device may be electrically connected by a known structure and/or method. The semiconductor device may be electrically connected to a wiring pattern in the semiconductor system.

FIG. 14 shows a schematic view of a circuit diagram of power supply of a semiconductor system according to an example of a present disclosure. FIG. 14 illustrates a power supply circuit 191 of a power supply device, including a power circuit and a control circuit. A DC voltage is switched at high frequencies by an inverter 192 (configured with MOSFET A to D) to be converted to AC, followed by insulation and transformation by a transformer 193. The voltage is then rectified by rectification MOSFETs 194 and then smoothed by a DCL 195 (smoothing coils L1 and L2) and a capacitor to output a direct current voltage. At this point, the output voltage is compared with a reference voltage by a voltage comparator 197 to control the inverter and the rectification MOSFETs by a PWM control circuit 196 to have a desired output voltage.

### (Example VII)

### 1. Formation of n⁺-type Semiconductor Layer

### 1-1. Film Formation Apparatus

Regarding a film-formation apparatus, a mist CVD apparatus 1 used in an example of method according to a present disclosure is described below with FIG. 5. The mist CVD apparatus 1 includes a carrier gas source 2a, a first flow-control valve 3a that is configured to control a flow of carrier gas sent from the carrier gas source 2a, a diluted carrier gas source 2b, a second flow-control valve 3a that is configured to control a flow of diluted carrier gas sent from the diluted carrier gas source 2b, a mist generator 4 containing a raw material solution 4a, a container 5 containing water 5a, an ultrasonic transducer 6 attached to a bottom of the container 5, a film-formation chamber 7, a supply pipe 9 connecting from the mist generator 4 to the film-formation chamber 7, a hot plate 8 arranged in the film-formation chamber 7, and an air duct 11 that is configured to emit mist after thermal reaction, droplets, and gas that is used. Also, a substrate 10 may be set on the hot plate 8.

### 1-2. Preparation of a Raw-Material Solution

Tin bromide was mixed to a 0.1 M aqueous gallium bromide solution, and the aqueous gallium bromide solution containing tin bromide was prepared to have an atomic ratio of tin to gallium that is 1:0.08, and at this point, deuterated hydrobromic acid (deuterium bromide in D₂O) was contained in the aqueous gallium bromide solution containing tin bromide to have a volume ratio of 10% of the aqueous solution that would be a raw-material solution.

### 1-3. Film Formation Preparation

The raw-material solution 4a obtained at 1-2. the Preparation of the Raw-Material Solution was set in the mist generator 4. Then, a sapphire substrate was placed on the hot plate 8 as a substrate 10, and the hot plate 8 was activated to raise the temperature in the film-formation chamber 7 up to 525°C. The first flow-control valve 3a and the second flow-control valve 3b were opened to supply a carrier gas from the carrier gas source 2a and the diluted carrier gas source 2b, which are the source of carrier gas, into the film-formation chamber 7 to replace the atmosphere in the film-formation chamber 7 with the carrier gas sufficiently. After the atmosphere in the film formation chamber 7 was sufficiently replaced with the carrier gas, the flow rate of the carrier gas from the carrier gas source 2a was regulated at 5.0 L/min. and the diluted carrier gas from the diluted carrier gas source 2b was regulated at 0.5 L/min. In this example, nitrogen was used as the carrier gas.

### 1-4. Formation of a film that is a crystalline oxide semiconductor film

The ultrasonic transducer 6 was then vibrated at 2.4 MHz, and the vibration propagated through the water 5a to the raw material solution 4a to atomize the raw material solution 4a to form a mist 4b. The mist 4b was sent through a supply pipe 9 with the carrier gas and introduced in the film formation chamber 7. The mist was thermally reacted at 525°C under atmospheric pressure in the film formation chamber 7 to form a film on the substrate 10. The film that was obtained was a crystalline oxide semiconductor film with a thickness of 0.5 µm. The film formation time was 20 minutes.

### 1-5. Evaluation

Using an X-ray diffraction (XRD) device, a phase of the film obtained at 6-4 the formation of the film described above was identified as α-Ga₂O₃. The semiconductor film obtained in this example may be used as a semiconductor layer in a semiconductor device. The semiconductor layer may include a surface area that is 3 mm² or less.

### 2. Formation of n⁻-type Semiconductor Layer

### 2-1. Film Formation Apparatus

Regarding a film-formation apparatus, a mist CVD apparatus 19 used in an example method according to a present disclosure is described with FIG. 6. The mist CVD apparatus 19 may include a susceptor 21 on which a substrate 20 is placed. The mist CVD apparatus 19 includes a carrier gas supply device 22a, a first flow-control valve 23a to control a flow of a carrier gas that is configured to be sent from the carrier gas supply device 22a, a diluted carrier gas supply device 22b, a second flow-control valve 23b to control a flow of a carrier gas that is configured to be sent from the carrier gas supply device 22b, a mist generator 24 in that a raw material solution 24a is contained, a container 25 in that water 25a is contained, an ultrasonic transducer that may be attached to a bottom surface of the container 25, a supply pipe 27 that may be a quartz pipe with an inside diameter that may be 40 mm, and a heater 28 arranged at a peripheral portion of the supply pipe. The susceptor 21 includes a surface that is slanted off the horizontal and on that the substrate 20 is arranged. The susceptor 21 is made of quartz. Since the susceptor 21 and the supply pipe 27 that are configured to be a film-formation chamber are made of quartz, this configuration reduces a possibility that a foreign substance entering a film that is formed on the substrate 20.

### 2-2. Preparation of a Raw-Material Solution

Deuterium bromide acid was contained at a volume ratio of 20% in a 0.1 M aqueous gallium bromide solution to make a raw-material solution.

### 2-3. Film Formation Preparation

The raw-material solution 24a obtained at 2-2. the Preparation of the Raw-Material Solution above was set in the mist generator 24. Then, an n⁺-type semiconductor film that was separated from a sapphire substrate was placed on the susceptor 21, and the heater 28 was activated to raise the temperature in the film-formation chamber 27 up to 510°C. The first flow-control valve 23a and the second flow-control valve 23b were opened to supply a carrier gas from the carrier gas source 22a and the diluted carrier gas source 22b, which are the source of carrier gas, into the film-formation chamber 27 to replace the atmosphere in the film-formation chamber 27 with the carrier gas sufficiently. After the atmosphere in the film formation chamber 27 was sufficiently replaced with the carrier gas, the flow rate of the carrier gas from the carrier gas source 22a was regulated at 5.0 L/min. and the diluted carrier gas from the diluted carrier gas source 22b was regulated at 0.5 L/min. In this example, oxygen was used as the carrier gas.

### 2-4. Formation of a film that is a crystalline oxide semiconductor film

The ultrasonic transducer 26 was then vibrated at 2.4 MHz, and the vibration propagated through the water 25a to the raw material solution 24a to atomize the raw material solution 24a to form a mist. The mist was introduced in the film formation chamber 27 with the carrier gas. The mist was thermally reacted at 510°C under atmospheric pressure in the film formation chamber 27 to form a film on the substrate 20. The film that was obtained was a crystalline oxide semiconductor film with a thickness of 0.5 µm. The film formation time was 20 minutes.

### 2-5. Evaluation

Using an X-ray diffraction (XRD) device, a phase of the film obtained at 2-4 the formation of the film described above was identified as α-Ga₂O₃. The semiconductor film obtained in this example may be used as a semiconductor layer in a semiconductor device. The semiconductor layer may include a surface area that is 3 mm² or less.

### 3. Formation of a First Metal Layer (Schottky Electrode)

As shown in Fig. 3, on an n⁻-type semiconductor layer, a Pt layer, a Ti layer, and an Au layer were laminated respectively by electron beam evaporation. The Pt layer had a thickness of 10 nm, the Ti layer had a thickness of 4 nm, and the Au layer had a thickness of 175 nm.

### 4. Formation of a Second Metal Layer (Ohmic Electrode)

On an n⁺-type semiconductor layer, a Ti layer and an Au layer were laminated respectively by electron beam evaporation. The Ti layer had a thickness of 35 nm and the Au layer had a thickness of 175 nm.

### 5. Evaluation

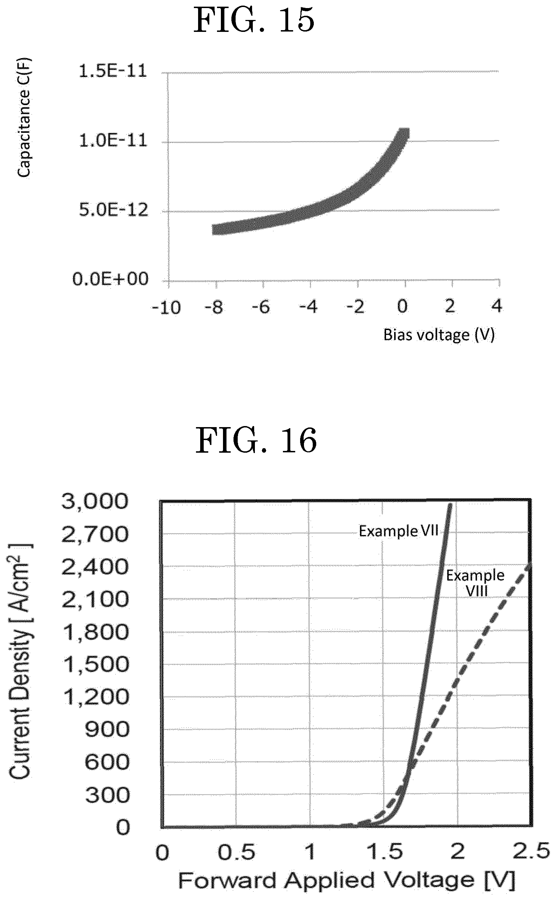

As mentioned above at Example VI, a semiconductor device was obtained according to a present disclosure and evaluated by a Capacitance-Voltage (CV) measurement. FIG. 15 shows the result of CV measurement.

An excess concentration of n-type dopant (a difference between n-type dopant concentration and an acceptable concentration of the n-type dopant) was calculated to be 3×10¹⁷/cm³.

Also, forward JV measurement was done with the semiconductor device that was obtained at Example VI. FIG. 16 shows the result of forward JV measurement of the semiconductor device of Example VI. The rising voltage was 1.5V. Also, on-resistance (differential resistance) was checked and found to be 0.1 mΩcm², that was significantly low.

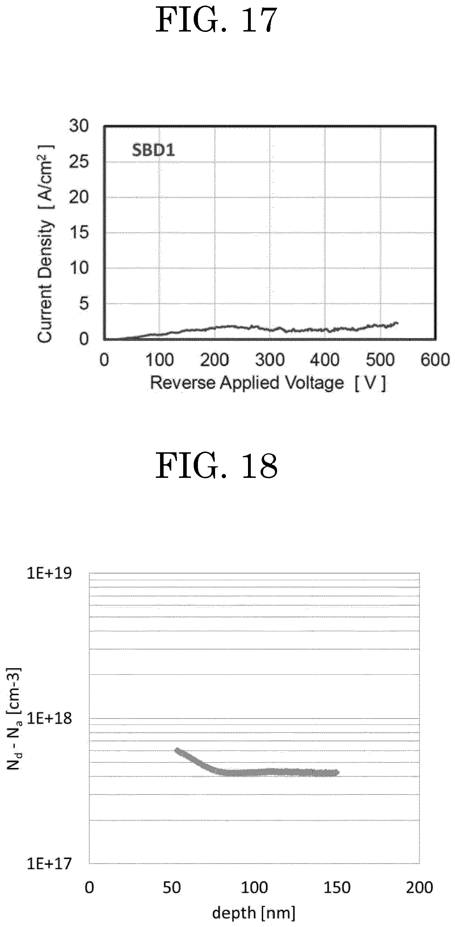

Furthermore, backward JV measurement was done with the semiconductor device that was obtained at Example VI, and FIG. 17 shows the result of backward JV measurement. Clearly shown in FIG. 17, a dielectric breakdown did not occur until the reverse voltage became 531V The µm field calculated by the excess concentration of n-type dopant and the voltage value causing the dielectric breakdown obtained as above was 11.0 MV/cm. These measurement results show that the semiconductor device obtained at Example VI was enhanced in semiconductor characteristics and Schottky characteristics.

### (Example VIII)

Another semiconductor device was obtained similarly to Example VII except one condition that the film formation time was set to be 120 minutes at Example VIII.

The thickness of n-type semiconductor layer of the semiconductor device was 3.6 µm. An excess concentration of n-type dopant (a difference between n-type dopant concentration and an acceptable concentration of the n-type dopant) was calculated to be 4-5 ×10¹⁷/cm³. FIG. 18 shows a distribution of the excess concentration of n-type dopant in a depth direction.

Also, forward JV measurement was done with the semiconductor device that was obtained at Example VIII. FIG. 16 shows the result of forward JV measurement of the semiconductor device of Example VIII. Also, on-resistance (differential resistance) was checked and found to be 0.4 mΩcm².

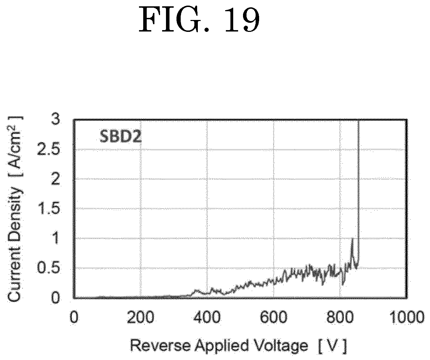

Furthermore, FIG. 19 shows the result of backward JV measurement done with the semiconductor device that was obtained at Example VIII, and FIG. 17 shows the result of backward JV measurement. Clearly shown in FIG. 19, a dielectric breakdown did not occur until the reverse voltage became 855V The breakdown field calculated by the excess concentration of n-type dopant and the voltage value causing the dielectric breakdown obtained as above was 11.1 MV/cm or more.

### Reference number description

- 1: a mist CVD (Chemical Vapor Deposition) apparatus
- 2a: a carrier gas source
- 2b: a diluted carrier gas source
- 3a: a first flow-control valve
- 3b: a second flow-control valve
- 4: a mist generator
- 4a: a raw material solution
- 4b: a mist
- 5: a container
- 5a: water
- 6: an ultrasonic transducer
- 7: a film-formation chamber
- 8: a hot plate
- 9: a supply pipe
- 10: a substrate
- 11: an air duct
- 19: a mist CVD Apparatus
- 20: a substrate
- 21: a susceptor
- 22a: a carrier gas supply device
- 22b: a diluted carrier gas supply device
- 23a: a first flow-control valve
- 23b: a second flow-control valve
- 24: a mist generator
- 24a: a raw material solution
- 25: a container
- 25a: water
- 26: an ultrasonic transducer
- 27: a supply pipe
- 28: a heater
- 29: an air duct
- 50a: a first metal layer
- 50b: a second metal layer
- 51: an Au layer
- 52: a Ti layer
- 53: a Pt layer
- 54: a Ti layer
- 55: an Au layer
- 101a: an n⁻-type semiconductor layer
- 101b: an n⁺-type semiconductor layer
- 105a: a Schottky electrode
- 105b: an Ohmic electrode

## Claims

1. A Schottky barrier diode, SBD, comprising:
a semiconductor layer comprising an n⁻-type first semiconductor layer (101a) and an n⁺-type second semiconductor layer (101b), the first semiconductor layer (101a) comprising α-Ga₂O₃, and the second semiconductor layer (101b) comprising α-Ga₂O₃, a Schottky electrode (105a) that is positioned on the first semiconductor layer (101a), and an ohmic electrode (105b) that is positioned on the second semiconductor layer (101b);
**characterised in that**
the semiconductor layer comprises a dielectric breakdown field that is 6 MV/cm or more, and the first semiconductor layer (101a) comprises a carrier concentration that is 1×10¹⁷/cm³ or more.

2. The Schottky barrier diode, SBD, according to claim 1,
wherein the Schottky electrode (105a) comprises at least one metal selected from the fourth group, the fifth group, the sixth group, the seventh group, the eighth group and the ninth group in the periodic table.

3. The Schottky barrier diode, SBD, according to claim 1
wherein the ohmic electrode (105b) comprises at least one metal selected from the fourth group or the eleventh group in the periodic table.

4. The Schottky barrier diode, SBD, according to claim 1, wherein a capacitance of the semiconductor device with a zero-bias voltage is 500pF or less when measured at 1 MHz.

5. The Schottky barrier diode, SBD, according to claim 1,
wherein the SBD is a power semiconductor device.

6. The Schottky barrier diode, SBD, according to claim 1,
wherein the first semiconductor layer (101a) with a first thickness and the second semiconductor layer (101b) with a second thickness are 40 µm or less as a total thickness of the first thickness of the first semiconductor layer (101a) and the second thickness of the second semiconductor layer (101b).

7. A semiconductor system comprising:
a motherboard; and
a Schottky barrier diode, SBD, according to claim 1 electrically connected to the motherboard.

## Patentansprüche

1. Schottky-Barrierediode, SBD, umfassend:
eine Halbleiterschicht, die eine erste Halbleiterschicht (101a) vom n⁻-Typ und eine zweite Halbleiterschicht vom n⁺-Typ (101b) umfasst, wobei die erste Halbleiterschicht (101a) α-Ga₂O₃ umfasst und die zweite Halbleiterschicht (101b) α-Ga₂O₃ umfasst,
eine Schottky-Elektrode (105a), die auf der ersten Halbleiterschicht (101a) angeordnet ist, und eine ohmsche Elektrode (105b), die auf der zweiten Halbleiterschicht (101b) angeordnet ist;
**dadurch gekennzeichnet, dass**
die Halbleiterschicht ein dielektrisches Durchschlagfeld umfasst, das 6 MV/cm oder mehr beträgt, und die erste Halbleiterschicht (101a) eine Trägerkonzentration umfasst, die 1 x 10¹⁷/cm³ oder mehr beträgt.

2. Schottky-Barrierediode, SBD, nach Anspruch 1,
wobei die Schottky-Elektrode (105a) mindestens ein Metall umfasst, das ausgewählt ist aus der vierten Gruppe, der fünften Gruppe, der sechsten Gruppe, der siebten Gruppe, der achten Gruppe und der neunten Gruppe im Periodensystem.

3. Schottky-Barrierediode, SBD, nach Anspruch 1,
wobei die ohmsche Elektrode (105b) mindestens ein Metall umfasst, das ausgewählt ist aus der vierten Gruppe oder der elften Gruppe im Periodensystem.

4. Schottky-Barrierediode, SBD, nach Anspruch 1, wobei bei Messung bei 1 MHz eine Kapazität der Halbleitervorrichtung mit einer Nullvorspannung 500 pF oder weniger beträgt.

5. Schottky-Barrierediode, SBD, nach Anspruch 1, wobei es sich bei der SBD um eine Leistungshalbleitervorrichtung handelt.

6. Schottky-Barrierediode, SBD, nach Anspruch 1,
wobei die erste Halbleiterschicht (101a) mit einer ersten Stärke und die zweite Halbleiterschicht (101b) mit einer zweiten Stärke als eine Gesamtstärke aus der ersten Stärke der ersten Halbleiterschicht (101a) und der zweiten Stärke der zweiten Halbleiterschicht (101b) 40 µm oder weniger aufweisen.

7. Halbleitersystem, umfassend:
eine Hauptplatine; und
eine Schottky-Barrierediode, SBD, nach Anspruch 1, die elektrisch mit der Hauptplatine verbunden ist.

## Revendications

1. Diode Schottky, SBD, comprenant :
une couche semi-conductrice comprenant une première couche semi-conductrice de type n⁻ (101a) et une deuxième couche semi-conductrice de type n⁺ (101b), la première couche semi-conductrice (101a) comprenant α-Ga₂O₃ et la deuxième couche semi-conductrice (101b) comprenant α-Ga₂O₃,
une électrode Schottky (105a) qui est positionnée sur la première couche semi-conductrice (101a) et une électrode ohmique (105b) qui est positionnée sur la deuxième couche semi-conductrice (101b) ;
**caractérisée en ce que**
la couche semi-conductrice comprend un champ de rupture diélectrique qui est de 6 MV/cm ou plus et la première couche semi-conductrice (101a) comprend une concentration de porteurs qui est de 1 x 10¹⁷/cm³ ou plus.

2. Diode Schottky, SBD, selon la revendication 1,
l'électrode Schottky (105a) comprenant au moins un métal sélectionné parmi le quatrième groupe, le cinquième groupe, le sixième groupe, le septième groupe, le huitième groupe et le neuvième groupe dans le tableau périodique.

3. Diode Schottky, SBD, selon la revendication 1,
l'électrode ohmique (105b) comprenant au moins un métal sélectionné parmi le quatrième groupe ou le onzième groupe dans le tableau périodique.

4. Diode Schottky, SBD, selon la revendication 1, une capacité du dispositif semi-conducteur avec une tension de polarisation nulle étant de 500 pF ou moins lorsque mesuré à 1 MHz.

5. Diode Schottky, SBD, selon la revendication 1,
la SBD étant un dispositif semi-conducteur de puissance.

6. Diode Schottky, SBD, selon la revendication 1,
la première couche semi-conductrice (101a) avec une première épaisseur et la deuxième couche semi-conductrice (101b) avec une deuxième épaisseur étant de 40 µm ou moins comme épaisseur totale de la première épaisseur de la première couche semi-conductrice (101a) et de la deuxième épaisseur de la deuxième couche semi-conductrice (101b).

7. Système semi-conducteur comprenant :
une carte mère ; et
une diode Schottky, SBD, selon la revendication 1, connectée électriquement à la carte mère.
